(19) Europäisches Patentamt / European Patent Office / Office européen des brevets

(11) **EP 4 443 737 B1**

(12) **EUROPEAN PATENT SPECIFICATION**

(45) Date of publication and mention of the grant of the patent:
**19.11.2025 Bulletin 2025/47**

(21) Application number: **22912982.0**

(22) Date of filing: **10.03.2022**

(51) International Patent Classification (IPC):
$H02P\ 21/14^{(2016.01)}$    $H02P\ 21/18^{(2016.01)}$
$H02P\ 27/08^{(2006.01)}$    $G01R\ 19/00^{(2006.01)}$
$H02P\ 21/13^{(2006.01)}$    $H02P\ 21/22^{(2016.01)}$

(52) Cooperative Patent Classification (CPC):
**H02P 21/14; G01R 19/0092; H02P 21/13; H02P 21/18; H02P 21/22; H02P 27/08**

(86) International application number:
**PCT/CN2022/080240**

(87) International publication number:
**WO 2023/123676 (06.07.2023 Gazette 2023/27)**

(54) **SINGLE-RESISTOR MEASUREMENT METHOD, ELECTRIC MOTOR CONTROL METHOD, ELECTRIC MOTOR CONTROLLER, AND ELECTRIC MOTOR CONTROL SYSTEM**

MESSVERFAHREN MIT EINEM WIDERSTAND, ELEKTROMOTORSTEUERUNGSVERFAHREN, ELEKTROMOTORSTEUERUNG UND ELEKTROMOTORSTEUERUNGSSYSTEM

PROCÉDÉ DE MESURE À RÉSISTANCE UNIQUE, PROCÉDÉ DE COMMANDE DE MOTEUR ÉLECTRIQUE, DISPOSITIF DE COMMANDE DE MOTEUR ÉLECTRIQUE ET SYSTÈME DE COMMANDE DE MOTEUR ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.12.2021 CN 202111655481**

(43) Date of publication of application:
**09.10.2024 Bulletin 2024/41**

(73) Proprietor: **Guangdong Welling Motor Manufacturing Co., Ltd.**
**Foshan, Guangdong 528311 (CN)**

(72) Inventors:
• **BIN, Hong**
  **Foshan, Guangdong 528311 (CN)**
• **ZHANG, Kai**
  **Foshan, Guangdong 528311 (CN)**
• **ZHAO, Xiaoan**
  **Foshan, Guangdong 528311 (CN)**
• **YANG, Haijin**
  **Foshan, Guangdong 528311 (CN)**

(74) Representative: **RGTH Patentanwälte PartGmbB**
**Neuer Wall 10**
**20354 Hamburg (DE)**

(56) References cited:
CN-A- 101 769 953    CN-A- 106 059 434
CN-A- 107 834 927    CN-A- 111 740 674
US-A1- 2002 030 464    US-A1- 2020 274 471

• PATEL A ET AL: "Current Sensing for Automotive Electronics-A Survey", IEEE TRANSACTIONS ON VEHICULAR TECHNOLOGY, IEEE, USA, vol. 58, no. 8, 1 October 2009 (2009-10-01), pages 4108 - 4119, XP011268604, ISSN: 0018-9545, DOI: 10.1109/ TVT.2009.2022081
• YE, WEIMIN ET AL.: "Current Sampling and Phase Current Reconstruction Method Based on MOSFET Internal Resistance", ELECTRONIC TECHNOLOGY & SOFTWARE ENGINEERING, no. 70, 15 October 2015 (2015-10-15), pages 137 - 139, XP009547513

Processed by Luminess, 75001 PARIS (FR)

**Description**

**CROSS-REFERENCE TO RELATED APPLICATION**

The present application claims a priority to Chinese Patent Application No. 202111655481.6, filed on December 30, 2021, and entitled "SINGLE-RESISTOR MEASUREMENT METHOD, MOTOR CONTROL METHOD, CONTROLLER, AND CONTROL SYSTEM".

**FIELD**

The present disclosure relates to the field of motor control technologies, and more particularly, to a single-resistor measurement method, a motor control method, a motor controller, a computer-readable storage medium, and a motor control system.

BACKGROUND

In the field of home appliance motor control or small and lightweight electric vehicle control, based on considerations of cost and space, motor controllers mostly use a single-resistor current sampling method to control a motor, and discrete devices are extensively used for implementing switching devices. However, when using a single resistor for current sampling, there exists a current sampling dead zone (that is, a non-observation region). A common problem-solving method is a PWM (Pulse Width Modulation) phase shift, but this is likely to lead to asymmetry of three-phase PWM, thus introducing current harmonics, which in turn leads to an increase in motor noise, and fails to satisfy requirements of applications with low noise-tolerance. Using three resistors or two resistors on a lower bridge arm for current sampling can effectively avoid sampling the dead zone and the motor noise, but this increases current sampling cost and introduces additional power consumption.
Prior art can be found in patent document US2020/274471.

SUMMARY

The present disclosure aims to solve at least one of the technical problems in the related art. To this end, a first object of the present disclosure is to provide a single-resistor measurement method for a motor control system, which effectively restores a three-phase feedback current of a motor by obtaining a three-phase current outside a dead zone based on single-resistor sampling and obtaining a three-phase current inside the dead zone based on an on-tube voltage drop and a switch-on resistance when a lower tube is switched on, and which does not need to perform a PWM phase shift, effectively avoiding a problem of an increase in motor noise caused by the PWM phase shift for current measurement in the dead zone. Meanwhile, using a single resistor for current sampling avoids problems of high current sampling cost and introduction of additional power consumption caused by using a plurality of resistors for the current sampling.
A second object of the present disclosure is to provide a motor control method.
A third object of the present disclosure is to provide a motor controller.
A fourth object of the present disclosure is to provide a computer-readable storage medium.
The fifth object of the present disclosure is to provide a motor control system.
In order to achieve the above objects, an embodiment in a first aspect of the present disclosure provides a single-resistor measurement method for a motor control system. The motor control system includes a three-phase inverter bridge and a single sampling resistor arranged corresponding to a negative pole of a direct-current bus. The three-phase inverter bridge is configured to drive a motor to operate. The method includes: obtaining a direct-current bus current flowing through the single sampling resistor, and determining, based on the direct-current bus current, a switch-on current when a lower tube of at least one phase bridge arm in the three-phase inverter bridge is switched on; obtaining an on-tube voltage drop when the lower tube of the at least one phase bridge arm in the three-phase inverter bridge is switched on; determining, based on the switch-on current and the on-tube voltage drop when the lower tube of the at least one phase bridge arm in the three-phase inverter bridge is switched on, a switch-on resistance when the lower tube of the at least one phase bridge arm in the three-phase inverter bridge is switched on; and determining, based on the direct-current bus current, a three-phase current outside a current measurement dead zone; determining, based on the on-tube voltage drop and the switch-on resistance, a three-phase current inside the current measurement dead zone; and determining, based on the three-phase current outside the current measurement dead zone and the three-phase current inside the current measurement dead zone, a three-phase feedback current of the motor.
According to the single-resistor measurement method for the motor control system of the embodiment of the present disclosure, a direct-current bus current flowing through the single sampling resistor is obtained, and the three-phase current outside the current measurement dead zone is determined based on the direct-current bus current. At the same time, the switch-on current when the lower tube of the at least one phase bridge arm in the three-phase inverter bridge is switched on is determined based on the direct-current bus current, the on-tube voltage drop when the lower tube of the at least one phase bridge arm in the three-phase inverter bridge is switched on is obtained, the switch-on resistance when the lower tube is switched on is determined based on the switch-on current and the on-tube voltage drop when the lower tube is switched on, and the three-phase current inside the current measurement dead zone is determined based on the on-tube voltage drop and the switch-on resistance; and finally, the three-phase feedback current of the motor is determined based on the three-phase current outside the current measurement dead zone and the three-phase current within the current measurement dead zone. As such, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling.

According to an embodiment of the present disclosure, the method further includes: obtaining an off-tube voltage drop when the lower tube of the at least one phase bridge arm in the three-phase inverter bridge is switched off; and determining, based on the off-tube voltage drop, a three-phase output line voltage of the motor and a direct-current bus voltage of the motor.

According to an embodiment of the present disclosure, the method further includes, prior to the obtaining the direct-current bus current and the on-tube voltage drop: determining a first sampling window time period, a second sampling window time period, and a third sampling window time period. The first sampling window time period is a time period starting from a time point of underflow interrupt of a PWM triangular waveform to a time point when an upper tube of any phase bridge arm in the three-phase inverter bridge is switched on. The second sampling window time period is a time period starting from a time point when the upper tube of any phase bridge arm in the three-phase inverter bridge is switched on and delayed for a first predetermined time period to a time point when an upper tube of a next phase bridge arm in the three-phase inverter bridge is switched on. The third sampling window time period is a time period starting from a time point when the upper tube of the next phase bridge arm in the three-phase inverter bridge is switched on and delyed for the first predetermined time period to a time point when an upper tube of a last phase bridge arm in the three-phase inverter bridge is switched on.

According to one embodiment of the present disclosure, the determining, based on the direct-current bus current, the switch-on current when the lower tube of the at least one phase bridge arm in the three-phase inverter bridge is switched on includes: obtaining a phase current of the motor by sampling the direct-current bus current during the second sampling window time period and the third sampling window time period; and determining, based on the phase current of the motor, the switch-on current when the lower tube of the at least one phase bridge arm in the three-phase inverter bridge is switched on.

According to an embodiment of the present disclosure, the obtaining the on-tube voltage drop when the lower tube of the at least one phase bridge arm in the three-phase inverter bridge is switched on includes: obtaining the on-tube voltage drop when the lower tube of the at least one phase bridge arm in the three-phase inverter bridge is switched on by sampling on-tube voltage drops during at least one of the first sampling window time period, the second sampling window time period, and the third sampling window time period.

According to an embodiment of the present disclosure, the method further includes, prior to the obtaining the off-tube voltage drop: determining, based on a time sequence of switching tubes to be switched on in the three-phase inverter bridge, a fourth sampling window time period. The fourth sampling window time period is a time period starting from a time point of overflow interrupt of a PWM triangular waveform to a time point when an upper tube of any phase bridge arm in the three-phase inverter bridge is switched off.

According to an embodiment of the present disclosure, the obtaining the off-tube voltage drop when the lower tube of the at least one phase bridge arm in the three-phase inverter bridge is switched off includes: obtaining the off-tube voltage drop when the lower tube of the at least one phase bridge arm in the three-phase inverter bridge is switched off by sampling off-tube voltage drops during at least one of the second sampling window time period, the third sampling window time period, and the fourth sampling window time period.

In order to achieve the above objects, an embodiment in a second aspect of the present disclosure provides a motor control method. The method includes: obtaining the three-phase feedback current of the motor and a three-phase output line voltage of the motor by performing the single-resistor measurement method for the motor control system described above; obtaining a direct-current current and a quadrature-axis current by performing a coordinate transformation to the three-phase feedback current, and obtaining a direct-axis voltage and a quadrature-axis voltage by performing a coordinate transformation to the three-phase output line voltage; obtaining a rotor angle and a rotor speed of the motor by performing a magnetic flux linkage and speed observation based on the direct-current current, the quadrature-axis current, the direct-axis voltage, and the quadrature-axis voltage; and performing vector control of the motor based on the direct-current current, the quadrature-axis current, the rotor angle, and the rotor speed.

According to the motor control method of the embodiment of the present disclosure, based on the single-resistor measurement method described above, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling. At the same time, the three-phase output line voltage is obtained based on the off-tube voltage drop of the lower tube, which effectively solves a problem of a significant discrepancy between the actual voltage and an estimated voltage caused by an estimation of a magnetic flux linkage and speed observer using an internally calculated command voltage during the vector control, which in turn causes a problem of control performance degradation such as low speed control accuracy and a small speed control range. In this way, a lower speed limit range and control accuracy of speed control are effectively improved.

In order to achieve the above objects, an embodiment in a third aspect of the present disclosure provides a motor controller. The motor controller includes a memory, a processor, and a single-resistor measurement program for a motor control system stored on the memory and executable on the processor. The processor is configured to, when running the single-resistor measurement program, implement the aforementioned single-resistor measurement method for the motor control system.

According to the motor controller of the embodiment of the present disclosure, based on the single-resistor measurement method described above, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling.

In order to achieve the above objects, an embodiment in a fourth aspect of the present disclosure provides a computer-readable storage medium. The computer-readable storage medium has a single-resistor measurement program for a motor control system stored thereon. The single-resistor measurement program for the motor control system is configured to, when executed by a processor, implement the aforementioned single-resistor measurement method for the motor control system.

According to the computer-readable storage medium of the embodiment of the present disclosure, based on the aforementioned single-resistor measurement method, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling.

In order to achieve the above objects, an embodiment in a fifth aspect of the present disclosure provides a motor control system. The motor control system includes a motor, a three-phase inverter bridge, a current measurement unit, a first voltage measurement unit, a second voltage measurement unit, a third voltage measurement unit, and a control unit. The three-phase inverter bridge is connected between direct-current buses and configured to drive the motor to operate. The current measurement unit includes a single sampling resistor, the single sampling resistor arranged corresponding to a negative pole of the direct-current bus and configured to measure a direct-current bus current. The first voltage measurement unit corresponds to a lower tube of a U-phase bridge arm in the three-phase inverter bridge and is configured to measure a lower tube voltage drop of the U-phase bridge arm. The second voltage measurement unit corresponds to a lower tube of a V-phase bridge arm in the three-phase inverter bridge and is configured to measure a lower tube voltage drop of the V-phase bridge arm. The third voltage measurement unit corresponds to a lower tube of a W-phase bridge arm in the three-phase inverter bridge and is configured to measure a lower tube voltage drop of the W-phase bridge arm. The control unit is configured to: determine, based on the direct-current bus current, a switch-on current when a lower tube of at least one phase bridge arm in the three-phase inverter bridge is switched on, obtain an on-tube voltage drop when the lower tube of the at least one phase bridge arm in the three-phase inverter bridge is switched on, determine, based on the switch-on current and the on-tube voltage drop when the lower tube of the at least one phase bridge arm in the three-phase inverter bridge is switched on, a switch-on resistance when the lower tube of the at least one phase bridge arm in the three-phase inverter bridge is switched on, determine, based on the direct-current bus current, a three-phase current outside a current measurement dead zone, and determine, based on the on-tube voltage drop and the switch-on resistance, a three-phase current inside the current measurement dead zone. The control unit is further configured to determine, based on the three-phase current outside the current measurement dead zone and the three-phase current inside the current measurement dead zone, a three-phase feedback current of the motor.

According to the motor control system of the embodiment of the present disclosure, a direct-current bus current flowing through the single sampling resistor is obtained, and the three-phase current outside the current measurement dead zone is determined based on the direct-current bus current. At the same time, the switch-on current when the lower tube of the at least one phase bridge arm in the three-phase inverter bridge is switched on is determined based on the direct-current bus current, the on-tube voltage drop when the lower tube of the at least one phase bridge arm in the three-phase inverter bridge is switched on is obtained, the switch-on resistance when the lower tube is switched on is determined based on the switch-on current and the on-tube voltage drop when the lower tube is switched on, and the three-phase current inside the current measurement dead zone is determined based on the on-tube voltage drop and the switch-on resistance; and finally, the three-phase feedback current of the motor is determined based on the three-phase current outside the current measurement dead zone and the three-phase current within the current measurement dead zone. As such, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling.

According to an embodiment of the present disclosure, the control unit is further configured to obtain an off-tube voltage drop when the lower tube of the at least one phase bridge arm in the three-phase inverter bridge is switched off and determine, based on the off-tube voltage drop, a three-phase output line voltage of the motor and a direct-current bus voltage of the motor.

According to an embodiment of the present disclosure, the control unit is further configured to: obtain the three-phase feedback current of the motor and a three-phase output line voltage of the motor by performing the single-resistor measurement method for the motor control system described above; obtain a direct-current current and a quadrature-axis current by performing a coordinate transformation to the three-phase feedback current, and obtaining a direct-axis voltage and a quadrature-axis voltage by performing a coordinate transformation to the three-phase output line voltage; obtain a rotor angle and a rotor speed of the motor by performing a magnetic flux linkage and speed observation based on the direct-current current, the quadrature-axis current, the direct-axis voltage, and the quadrature-axis voltage; and perform vector control of the motor based on the direct-current current, the quadrature-axis current, the rotor angle, and the rotor speed.

Additional aspects and advantages of the embodiments of present disclosure will be provided at least in part in the following description, or will become apparent in part from the following description, or can be learned from the practice of the embodiments of the present disclosure.

## BRIEF DESCRIPTION OF THE DRAWINGS

FIG. 1 is a schematic structural view of a motor control system according to an embodiment of the present disclosure.
FIG. 2 is a schematic flowchart of a single-resistor measurement method according to an embodiment of the present disclosure.
FIG. 3 is a sector diagram of space voltage vector control.
FIG. 4 is a schematic diagram of sampling of a voltage and a current according to an embodiment of the present disclosure.
FIG. 5 is a schematic flowchart of a motor control method according to an embodiment of the present disclosure.
FIG. 6 is a topology diagram of motor vector control according to an embodiment of the present disclosure.
FIG. 7 is a schematic structural view of a voltage measurement unit according to an embodiment of the present disclosure.

## DETAILED DESCRIPTION

The embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain rather than limit the present disclosure.

In the embodiments of the present disclosure, the motor control system may include a three-phase inverter bridge and a single sampling resistor. The three-phase inverter bridge is configured to drive the motor to operate, and the single sampling resistor corresponds to a negative pole of a direct-current bus.

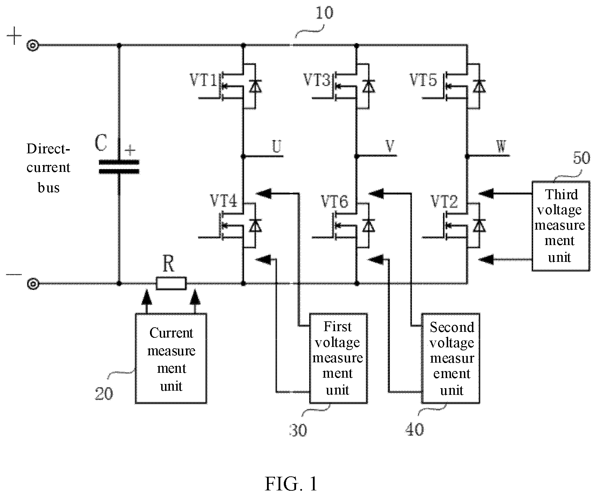

In an embodiment, as illustrated in FIG. 1, the three-phase inverter bridge includes a U-phase bridge arm, a V-phase bridge arm, and a W-phase bridge arm. The U-phase bridge arm includes an upper tube VT1 and a lower tube VT4. The V-phase bridge arm includes an upper tube VT3 and a lower tube VT6. The W-phase bridge arm includes an upper tube VT5 and a lower tube VT2. The upper tube VT1 has a first terminal connected to a positive pole of the direct-current bus, and the lower tube VT4 has a first terminal connected to a second terminal of the upper tube VT1 and a second terminal connected to the negative pole of the direct-current bus. The upper tube VT3 has a first terminal connected to the positive pole of the direct-current bus, and the lower tube VT6 has a first terminal connected to a second terminal of the upper tube VT3 and a second terminal connected to the negative pole of the direct-current bus. The upper tube VT5 has a first terminal connected to the positive pole of the direct-current bus, and the lower tube VT2 has a first terminal connected to a second terminal of the upper tube VT5 and a second terminal connected to the negative pole of the direct-current bus. A control terminal of each of the upper tube VT1, the lower tube VT4, the upper tube VT3, the lower tube VT6, the upper tube VT5, and the lower tube VT2 is connected to a control unit. The control unit may include a single chip microcomputer with a memory, a digital signal processing (DSP) and other control devices. The control unit controls on or off of the six switching tubes to invert a direct current on the direct current bus into an alternating current, and the alternating current is provided to a back-end load such as a motor to allow the motor to operate. The direct current may source form a battery and may also be obtained by rectifying the alternating current, which are not limited herein. A direct-current bus capacitor is disposed between the positive pole and the negative pole of the direct-current bus for energy storage and voltage stabilization, and the negative pole of the direct-current bus is connected in series to a single sampling resistor R, through which current sampling is performed.

When using the single resistor for the current sampling, there exists a current sampling dead zone. A common problem-solving method is a PWM phase shift, but this is likely to lead to asymmetry of three-phase PWM, thus introducing current harmonics, which in turn leads to an increase in motor noise, and fails to satisfy requirements of applications with low noise-tolerance. Using three resistors or two resistors on a lower bridge arm for current sampling can effectively avoid sampling the dead zone and the motor noise, but this increases current sampling cost and introduces additional power consumption. Based on this, the present disclosure provides a single-resistor measurement method, capable of realizing current sampling in a dead zone without a PWM phase shift, avoiding the problem of the increase in the motor noise caused by the PWM phase shift for the current measurement in the dead zone. Meanwhile, using the single resistor for the current sampling avoids the problems of the high current sampling cost and the introduction of additional power consumption caused by using the plurality of resistors for the current sampling.

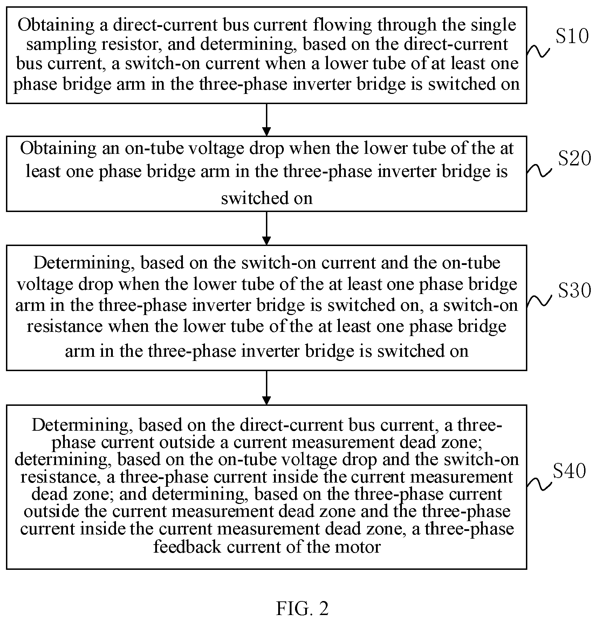

FIG. 2 is a schematic flowchart of a single-resistor measurement method according to an embodiment of the present disclosure. Referring to FIG. 2, the single-resistor measurement method may include actions at steps S10 to S40.

At step S10, a direct-current bus current flowing through the single sampling resistor is obtained, and a switch-on current when a lower tube of at least one phase bridge arm in the three-phase inverter bridge is switched on is determined based on the direct-current bus current.

It should be noted that the switch-on current refers to a current flowing through a switching tube when the switching tube is switched on. As illustrated in FIG. 1, a switch-on current of the lower tube VT4 is a current flowing through the lower tube VT4 when the lower tube VT4 is switched on, a switch-on current of the lower tube VT6 is a current flowing through the lower tube VT6 when the lower tube VT6 is switched on, and a switch-on current of the lower tube VT2 is a current flowing through the lower tube VT2 when the lower tube VT2 is switched on. Because there is a correlation between the direct-current bus current and the switch-on current of the lower tube, the switch-on currents of the lower tubes VT4, VT6, and VT2 can be obtained based on the direct-current bus current. For example, switch-on currents of some switching tubes in the lower tubes VT4, VT6, and VT2 can be obtained directly based on a loop current trend when the switching tube is switched on, while switch-on currents of other switching tubes can be obtained based on a single resistor current reconstruction method. Therefore, it is not necessary to set a sampling resistor and a current measurement unit for each lower tube, which is beneficial to reducing cost and space occupation.

At step S20, an on-tube voltage drop is obtained when the lower tube of the at least one phase bridge arm in the three-phase inverter bridge is switched on.

It should be noted that the on-tube voltage drop refers to a voltage difference between the first terminal and the second terminal of the switching tube when the switching tube is switched on. As illustrated in FIG. 1, the on-tube voltage drop of the lower tube VT4 is a voltage difference between the first terminal and the second terminal of the lower tube VT4 when the lower tube VT4 is switched on, the on-tube voltage drop of the lower tube VT6 is a voltage difference between the first terminal and the second terminal of the lower tube VT6 when the lower tube VT6 is switched on, and the on-tube voltage drop of the lower tube VT2 is a voltage difference between the first terminal and the second terminal of the lower tube VT2 when the lower tube VT2 is switched on.

When obtaining the on-tube voltage drop of the lower tube, a voltage measurement unit can correspond to each lower tube, and the voltage measurement unit can detect the on-tube voltage drop of the corresponding lower tube. As illustrated in FIG. 1, a first voltage measurement unit corresponds to the lower tube VT4, and the on-tube voltage drop of the lower tube VT4 is measured by the first voltage measurement unit. A second voltage measurement unit corresponds to the lower tube VT6, and the on-tube voltage drop of the lower tube VT6 is measured by the second voltage measurement unit. A third voltage measurement unit corresponds to the lower tube VT2, and the on-tube voltage drop of the lower tube VT2 is measured by the third voltage measurement unit.

At step S30, a switch-on resistance when the lower tube of the at least one phase bridge arm in the three-phase inverter bridge is switched on is determined based on the switch-on current and the on-tube voltage drop when the lower tube of the at least one phase bridge arm in the three-phase inverter bridge is switched on.

In an embodiment, when the on-tube voltage drop and the switch-on current of the switching tube are obtained, a resistance can be calculated based on a relationship between voltage and current, which is the switch-on resistance when the switching tube is switched on. As illustrated in FIG. 1, after the on-tube voltage drop and the switch-on current of the lower tube VT4 are obtained, a switch-on resistance of the lower tube VT4 can be calculated. After the on-tube voltage drop and the switch-on current of the lower tube VT6 are obtained, a switch-on resistance of the lower tube VT6 can be calculated. After the on-tube voltage drop and the switch-on current of the lower tube VT2 are obtained, a switch-on resistance of the lower tube VT2 can be calculated. It can be specifically calculated by the following formula (1):

$$R_{dson-real} = \frac{V_{ds(u,v,w)\_on}}{I_{(u,v,w)}} \qquad (1)$$

Where, $R_{dson-real}$ represents switch-on resistance, $V_{ds(u,v,w)\_on}$ represents on-tube voltage drop, and $V_{ds(u,v,w)\_on}$ represents switch-on current.

At step S40, a three-phase current outside a current measurement dead zone is determined based on the direct-current bus current; a three-phase current inside the current measurement dead zone is determined based on the on-tube voltage drop and the switch-on resistance; and a three-phase feedback current of the motor is determined based on the three-phase current outside the current measurement dead zone and the three-phase current inside the current measurement dead zone.

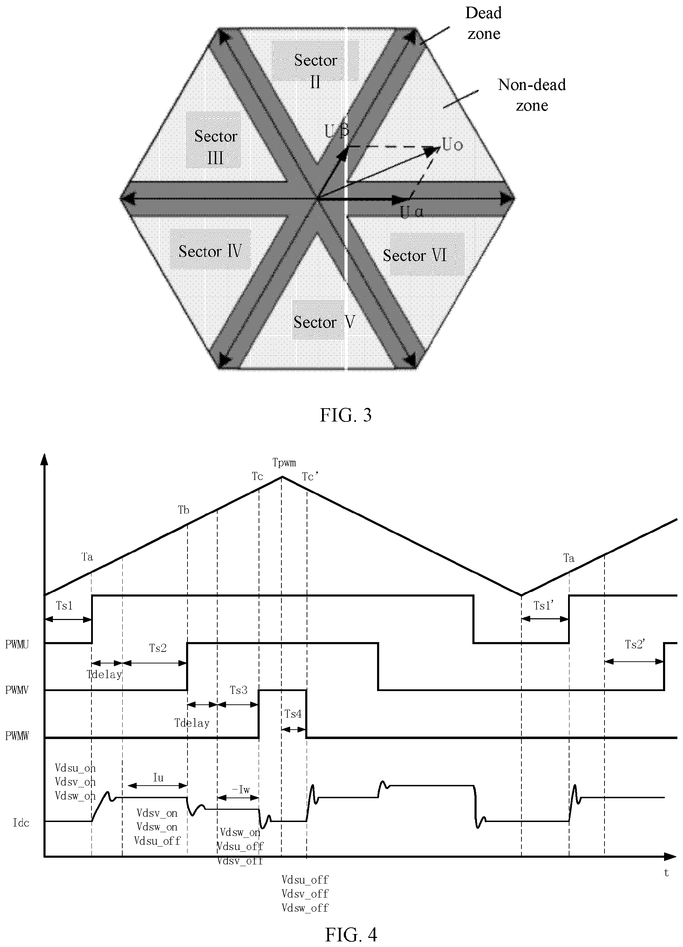

It should be noted that when generating PWM modulated waves, an output voltage is usually synthesized by two adjacent non-zero voltage vectors. As illustrated in FIG. 3, the output voltage Uo is synthesized by non-zero voltage vectors Uα and Uβ. When the output voltage Uo is near a boundary between adjacent sectors, a length of one of the non-zero voltage vectors will be very short, causing an insufficient single-resistor current sampling time period, thus leading to a dead zone during the current measurement. As illustrated in FIG. 3, a dark region is the current measurement dead zone, while in a light region, the current measurement has high accuracy. Therefore, in the present disclosure, the three-phase current of the motor outside the current measurement dead zone is obtained directly from the direct-current bus current. In the current measurement dead zone, the three-phase current of the motor is obtained based on on-tube voltage drop of the lower tube in the dead zone and the switch-on resistance of the lower tube is determined based on the action at step S30. The three-phase feedback current of the motor is obtained based on the three-phase currents inside and outside the current measurement dead zone.

When determining the three-phase current inside the current measurement dead zone, the three-phase current inside the current measurement dead zone can be obtained by dividing the on-tube voltage drop of the lower tube in the current measurement dead zone by the switch-on resistance of the corresponding lower tube, that is, the three-phase current inside the current measurement dead zone can be calculated by the following formula (2):

$$I'_{(u,v,w)} = \frac{V_{ds(u,v,w)\_on}}{R_{dson-real}} \qquad (2)$$

Where, $R_{dson-real}$ represents the switch-on resistance, $V_{ds(u,v,w)\_on}$ represents the on-tube voltage drop, and $I'_{(u,v,w)}$ represents a phase current inside the current measurement dead zone.

In the above embodiment, based on the single-resistor measurement method described above, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling. Moreover, compared with the scheme of directly obtaining the three-phase current inside the current measurement dead zone based on the on-tube voltage drop and a standard switch-on resistance, the switch-on resistance is an actual value that takes into accounts effects of various factors such as a temperature and a current, and the switch-on internal resistance cannot suddenly change in a short time period, that is, the switch-on current cannot suddenly change, the obtained three-phase current inside the dead zone has high accuracy and facilitates stability of the system.

In some embodiments of the present disclosure, the single-resistor measurement method further includes: obtaining an off-tube voltage drop when the lower tube of the at least one phase bridge arm in the three-phase inverter bridge is switched off; and determining, based on the off-tube voltage drop, a three-phase output line voltage of the motor and a direct-current bus voltage of the motor.

It should be noted that the off-tube voltage drop refers to a voltage difference between the first terminal and the second terminal of the switching tube when the switching tube is switched off. As illustrated in FIG. 1, an off-tube voltage drop of the lower tube VT4 is a voltage difference between the first terminal and the second terminal of the lower tube VT4 when the lower tube VT4 is switched off, the off-tube voltage drop of the lower tube VT6 a voltage difference between the first terminal and the second terminal of the lower tube VT6 when the lower tube VT6 is switched off, and the off-tube voltage drop of the lower tube VT2 is a voltage difference between the first terminal and the second terminal of the lower tube VT2 is switched off. After obtaining the off-tube voltage drop of the lower tube, the three-phase output line voltage of the motor and the direct-current bus voltage of the motor can be obtained based on the off-tube voltage drop.

In an embodiment, the off-tube voltage drop of the lower tube in the three-phase inverter bridge is equal to a terminal voltage of a negative pole of the three-phase direct-current bus (the negative pole is taken as a reference point N), that is, the terminal voltage satisfies the following formula (3):

$$\begin{cases} Vun = Vdsu\_off \\ Vvn = Vdsv\_off \\ Vwn = Vdsw\_off \end{cases} \qquad (3)$$

Where, Vun represents a terminal voltage of the U-phase, Vvn represents a terminal voltage of the V-phase, Vwn represents a terminal voltage of the W-phase, Vdsu_off represents an off-tube voltage drop of the lower tube of the U-phase, Vdsv_off represents an off-tube voltage drop of the lower tube of the V-phase, and Vdsw_off represents an off-tube voltage drop of the lower tube of the W-phase.

The three-phase output line voltage is represented as:

$$\begin{cases} Vuv = Vun\text{-}Vvn = Vdsu\_off\text{-}Vdsv\_off \\ Vvw = Vvn\text{-}Vwn = Vdsv\_off - Vdsw\_off \\ Vwu = Vwn\text{-}Vun = Vdsw\_off\text{-} Vdsu\_off \end{cases} \qquad (4)$$

Where Vuv represents a UV line voltage, Vvw represents a VW line voltage, and Vwu represents a WU line voltage.

The direct-current bus voltage is represented as:

$$Vdc = Vdsu\_off + Vds\_upu = Vdsv\_off + Vds\_upv = Vdsw\_off + Vds\_upv \qquad (5)$$

Where Vdc represents the direct-current bus voltage, Vds_upu represents an on-tube voltage drop of the upper tube of the U-phase, Vds_upv represents an on-tube voltage drop of the upper tube of the V-phase, and Vds_upw represents an on-tube voltage drop of the upper tube of the W-phase, and Vdc is much greater than Vds_upu, Vds_upv, and Vds_upw, that is, the direct-current bus voltage is much greater than the on-tube voltage drop of the upper tube of each phase. Therefore, the direct-current bus voltage can be obtained by simplifying the above formula (5) as:

$$Vdc = Vdsu\_off = Vdsv\_off = Vdsw\_off \qquad (6)$$

That is, the direct-current bus voltage is equal to the off-tube voltage drop of the lower tube of each phase.

Therefore, the three-phase output line voltage is obtained based on the off-tube voltage drop of the lower tube. Sensorless vector control is performed based on the three-phase output line voltage, which can effectively solve, in the process of vector control, when operating at a low voltage and a large current, control performance degradation problems such as low speed accuracy and small control range for low-speed control, when using an instruction voltage as an input to the magnetic flux linkage and speed observer and there is the large error between the instruction voltage and the actual voltage, for the output voltage has a dead zone factor, a tube voltage drop, and a line loss. In this way, a lower speed limit range and control accuracy of speed control are effectively improved. At the same time, the direct-current bus voltage can be obtained based on the off-tube voltage drop of the lower tube, and therefore other key parameters that can improve the vector control performance are obtained while realizing the single-resistor current measurement. Moreover, there is no need to set the output voltage measurement unit and the direct-current bus voltage measurement unit, which effectively reduces the cost and the space occupation.

In some embodiments of the present disclosure, the single-resistor measurement method further includes: determining a first sampling window time period, a second sampling window time period, and a third sampling window time period. The first sampling window time period is a time period starting from a time point of underflow interrupt of a PWM triangular waveform to a time point when an upper tube of any phase bridge arm in the three-phase inverter bridge is switched on. The second sampling window time period is a time period starting from a time point when the upper tube of any phase bridge arm in the three-phase inverter bridge is switched on and delayed for a first predetermined time period to a time point when an upper tube of a next phase bridge arm in the three-phase inverter bridge is switched on. The third sampling window time period is a time period starting from a time point when the upper tube of the next phase bridge arm in the three-phase inverter bridge is switched o and delayed for the first predetermined time period, to a time point when an upper tube of a last phase bridge arm in the three-phase inverter bridge is switched on.

Further, the single-resistor measurement method further includes: determining, based on a time sequence of switching tubes to be switched on in the three-phase inverter bridge, a fourth sampling window time period. The fourth sampling window time period is a time period starting from a time point of overflow interrupt of a PWM triangular waveform to a time point when an upper tube of any phase bridge arm in the three-phase inverter bridge is switched off.

It should be noted that the time point of the underflow interrupt refers to a time point when a timer of the triangular wave is interrupted at a bottom of the triangular waveform, that is, a time point reaching a valley of the triangular waveform; and the time point of the overflow interrupt refers to a time point when the timer of the triangular waveform is interrupted at a top of triangular waveform, that is, a time point reaching a peak of triangular waveform.

In an embodiment, as illustrated in FIG. 4, corresponding to different PWM U, PWM V, and PWM W voltage vector time points, after avoiding current fluctuation caused by a trigger of switching signals, time points corresponding to different collecting signals appear. At the bottom of the triangle waveform, the timer of the triangle waveform will have an underflow interrupt. At this time point, PWM U, PWM V, and PWM W each are 0, the upper tubes VT1, VT3, and VT5 of the three-phase bridge arm each are switched off, and the lower tubes VT4, VT6, and VT2 of the three-phase bridge arm each are switched on. The first sampling window time period Ts1 is a time period staring form this time point until any first activated upper tube is switched on (in an example illustrated in FIG. 4, the upper tube VT1 of the U-phase bridge arm serves as the first activated upper tube, and Ta is a time point when the upper tube VT1 of the U-phase bridge arm is switched on).

After the end of the first sampling window time period Ts1, the activation voltage vector changes, and after avoiding the current fluctuation caused by the trigger of the switching signals, the second sampling window time period Ts2 appears. The second sampling window time period Ts2 is a time period starting from a time point when any first activated upper tube is switched on (in the example illustrated in FIG. 4, the upper tube VT1 of the U-phase bridge arm serves as the first activated upper tube), and delayed for a first predetermined time period Tdelay to a time point when a second activated upper tube is switched on (in the example illustrated in FIG. 4, the upper tube VT3 of the V-phase bridge arm serves as the second activated upper tube, and Tb is a time point when the upper tube VT3 of the V-phase bridge arm is switched on).

After the end of the second sampling window time period Ts2, the activation voltage vector changes, and after avoiding the current fluctuation caused by the trigger of the switching signals, the third sampling window time period Ts3 appears. The third sampling window time period Ts3 is a time period starting from a time point when the second activated upper tube is switched on (in the example illustrated in FIG. 4, the upper tube VT3 of the V-phase bridge arm serves as the second activated upper tube) and delayed for the first predetermined time period Tdelay to a time point when a last activated upper tube is switched on (in the example illustrated in FIG. 4, the upper tube VT5 of the W-phase bridge arm serves as the last activated upper tube, and Tb is a time point when the upper tube VT5 of the W-phase bridge arm is switched on).

After the end of the third sampling window time period Ts3, the timer of the triangle waveform has the overflow interrupt at a time point Tpwm of the overflow interrupt, i.e., at the top of the triangle waveform. At this time point, PWM U, PWM V, and PWM W each are 1, the upper tubes VT1, VT3, and VT5 of the three-phase bridge arm each are switched on, and the lower tubes VT4, VT6, and VT2 of the three-phase bridge arm each are switched off. The fourth sampling window time period Ts4 is a time period staring form this time point until first deactivated upper tube is switched off (in the example illustrated in FIG. 4, the upper tube VT5 of the W-phase bridge arm serves as the first deactivated upper tube).

After the sampling window time periods Ts1, Ts2, Ts3, and Ts4 are determined, some or all of them can be taken as the sampling time points of the on-tube voltage drop, off-tube voltage drop, and the current of the lower tube. The voltage and the bus current are sampled by using the first voltage measurement unit, the second voltage measurement unit, the third voltage measurement unit, and the current measurement unit illustrated in FIG. 1, and finally the on-tube voltage drop, the off-tube voltage drop, and the switch-on current of the lower tube are obtained.

In some embodiments of the present disclosure, the determining, based on the direct-current bus current, the switch-on current when the lower tube of the at least one phase bridge arm in the three-phase inverter bridge is switched on includes: obtaining a phase current of the motor by sampling the direct-current bus current during the second sampling window time period and the third sampling window time period; and determining, based on the phase current of the motor, the switch-on current when the lower tube of the at least one phase bridge arm in the three-phase inverter bridge is switched on.

In an embodiment, as illustrated in FIG. 4, outside the current measurement dead zone, the sampling window time periods Ts2 and Ts3 are enough to complete the current sampling. Thus, during the sampling window time periods Ts2 and Ts3, the direct-current bus current is measured by the current measurement unit illustrated in FIG. 1, and two phase currents in the three-phase current of the motor are obtained based on the reduction of the direct-current bus current, and a third-phase current is calculated based on a single-resistor current reconstruction technology, that is, calculated based on a formula Iu+Iv+Iw=0, where Iu represents the U-phase current of the motor, Iv represents the V-phase current of the motor, and Iw represents the W-phase current of the motor. Furthermore, the switch-on current of the lower tube can be obtained based on the three-phase current. As illustrated in FIG. 1, the switch-on current of the lower tube VT4 is Iu, the switch-on current of the lower tube VT6 is Iv, and the switch-on current of the lower tube VT2 is Iw. Therefore, outside the current measurement dead zone, the three-phase current of the motor can be restored based on the single-resistor current measurement, and the switch-on current of the lower tube of each phase can be obtained simultaneously. As a result, the switch-on resistance of the lower tube of each phase can be obtained by using the switch-on current as the reference current, and then the three-phase current inside the current measurement dead zone can be restored based on the switch-on resistance, without the PWM phase shift.

In some embodiments of the present disclosure, the obtaining the on-tube voltage drop when the lower tube of the at least one phase bridge arm in the three-phase inverter bridge is switched on includes: obtaining the on-tube voltage drop when the lower tube of the at least one phase bridge arm in the three-phase inverter bridge is switched on by sampling on-tube voltage drops during at least one of the first sampling window time period, the second sampling window time period, and the third sampling window time period.

That is, some or all of the sampling window time periods Ts1, Ts2, and Ts3 can be taken as the sampling time points of the on-tube voltage drop of the lower tube. The on-tube voltage drop of the lower tube can be obtained by sampling the voltage of the lower tube with the first voltage measurement unit, the second voltage measurement unit, and the third voltage measurement unit illustrated in FIG. 1.

According to an embodiment of the present disclosure, the obtaining the off-tube voltage drop when the lower tube of the at least one phase bridge arm in the three-phase inverter bridge is switched off includes: obtaining the off-tube voltage drop when the lower tube of the at least one phase bridge arm in the three-phase inverter bridge is switched off by sampling off-tube voltage drops during at least one of the second sampling window time period, the third sampling window time period, and the fourth sampling window time period.

That is, some or all of the sampling window time periods Ts2, Ts3, and Ts4 can be taken as the sampling time points of the off-tube voltage drop of the lower tube. The off-tube voltage drop of the lower tube can be obtained by sampling the off-tube voltage with the first voltage measurement unit, the second voltage measurement unit, and the third voltage measurement unit illustrated in FIG. 1.

Further, as a first example, outside the current measurement dead zone, during the first sampling window time period, the on-tube voltage drop when the lower tube of each phase bridge arm is switched on can be obtained; during the second sampling window time period, the U-phase current, the on-tube voltage drop of the lower tube of the V-phase bridge arm, the on-tube voltage drop of the lower tube of the W-phase bridge arm, and the off-tube voltage drop of the lower tube of the U-phase bridge arm are obtained; during the third sampling window time period, the W-phase current, the on-tube voltage drop of the lower tube of the W-phase bridge arm, the off-tube voltage drop of the lower tube of the U-phase bridge arm, and the off-tube voltage drop of the lower tube of the V-phase bridge arm are obtained, or the V-phase current, the on-tube voltage drop of the lower tube of the V-phase bridge arm, the off-tube voltage drop of the lower tube of the U-phase bridge arm, and the off-tube voltage drop of the lower tube of the W-phase bridge arm are obtained; and during the fourth sampling window time period, the off-tube voltage drop of the lower tube of each phase bridge arm when the lower tube of each phase bridge arm is switched off can be obtained.

In an embodiment, as illustrated in FIG. 4, during the first sampling window time period Ts1, because the lower tubes VT4, VT6, and VT2 of the three-phase bridge arm each are switched on, on-tube voltage drops Vdsu_on, Vdsv_on, and Vdsw_on can be obtained by collecting the on-tube voltage drops of the lower tubes VT4, VT6, and VT2 simultaneously.

During the second sampling window time period Ts2, because, in the three-phase bridge arm, an upper tube of one phase bridge arm is in a state of being switched on and lower tubes of another two-phase bridge arm are in the state of being switched on, the direct-current bus has a current. In this case, a phase current of a phase where this upper tube is located can be obtained by sampling a direct-current bus current Idc, and an off-tube voltage drop of a lower tube of the phase where this upper tube is located and on-tube voltage drops of the lower tubes of the other two phases can be obtained simultaneously by the sampling. As illustrated in FIG. 4, during the second sampling window time period Ts2, because the upper tube VT1 of the U-phase bridge arm is in the state of being switched on, a U-phase current Iu can be obtained by sampling the direct-current bus current Idc, and the off-tube voltage drop Vdsu_off of the lower tube VT4, and the on-tube voltage drops Vdsv_on and Vdsw_on of the lower tubes VT6 and VT2 can be obtained simultaneously by the voltage sampling.

During the third sampling window time period Ts3, because, in the three-phase bridge arm, upper tubes of the two phase bridge arms each are in the state of being switched on and a lower tube of another one phase bridge arm is in the state of being switched on, the direct-current bus has a current. In this case, a phase current of a phase where this lower tube is located can be obtained by sampling the direct-current bus current Idc, and an on-tube voltage drop of this lower tube and an off-tube voltage drop of the lower tube of a phase where this upper tube is located can be obtained simultaneously by the sampling. As illustrated in FIG. 4, during the third sampling window time period Ts3, because the upper tube VT1 of the U-phase bridge arm and the upper tube VT3 of the V-phase bridge arm each are in the state of being switched on, a W-phase current Iw can be obtained by sampling the direct-current bus current Idc, and the off-tube voltage drops Vdsu_off and Vdsv_off of the lower tubes VT4 and VT6 and the on-tube voltage drop Vdsw_on of the lower tube VT2 can be obtained by the voltage sampling simultaneously. In some embodiments, during the third sampling window time period Ts3, because the upper tube VT1 of the U-phase bridge arm and the upper tube VT5 of the W-phase bridge arm each are in the state of being switched on (not illustrated in the figure), a V-phase current IV can be obtained by sampling the direct-current bus current Idc, and the off-tube voltage drops Vdsu_off and Vdsw_off of the lower tubes VT4 and VT2 and the on-tube voltage drop Vdsv_on of the lower tube VT6 can be obtained by the voltage sampling simultaneously. That is, the second activated upper tube may be the V phase or the W phase, and phase currents, on-tube voltage drops, and off-tube voltage drops corresponding to different phases are different when different phases are switched on.

During the second sampling window time period Ts4, because each of the upper tubes in the three-phase bridge arm is in the state of being switched on, each of the lower tubes in the three-phase bridge arm is in the state of being switched off, the off-tube voltage drop of each of the lower tubes can be obtained by the sampling, that is, the off-tube voltage drops Vdsu_off, Vdsv_off, and Vdsw_off of the lower tubes VT4, VT6, and VT2 can be obtained by the sampling.

It should be noted that when the first sampling window time period Ts1 and the fourth sampling window time period Ts4 are too short to complete the sampling of the off-tube voltage drops and the on-tube voltage drops of the three lower tubes, and distributed sampling of the off-tube voltage drop and the on-tube voltage drop of the corresponding lower tube can be performed at a time point when other vectors occur based on a vector state of the three-phase PWM being switched on. For example, the on-tube voltage drop Vdsu_on of the lower tube VT4 can be obtained by sampling the tube voltage drop of the lower tube VT4 during the first sampling window time period Ts1, and the on-tube voltage drops Vdsv_on and Vdsw_on are obtained by sampling the tube voltage drops of the lower tubes VT6 and VT2 during the second sampling window time period Ts2 respectively. The off-tube voltage drops Vdsu_off and Vdsv_off are obtained by sampling the tube voltage drops of the lower tubes VT4 and VT6 during the third sampling window time period Ts3 respectively, and the off-tube voltage drop Vdsw_off is obtained by sampling the tube voltage drop of the lower tube VT2 during the fourth sampling window time period Ts4. As such, the on-tube voltage drop and the off-tube voltage drop of each lower tube are obtained.

When the U-phase current Iu and the W-phase current Iw are obtained according to the above method, the V-phase current Iv can be calculated based on the zero sum of the three-phase currents, and when the U-phase current Iu and the V-phase current Iv are obtained according to the above method, the W-phase current Iw can be calculated based on the zero sum of the three-phase currents, thereby obtaining the three-phase currents Iu, Iv, and Iw of the motor outside the current measurement dead zone. The switch-on current Iu of the lower tube VT4 and the switch-on currents Iw of the lower tube VT4, VT6 can be obtained based on the three-phase currents.

Up to this point, outside the current measurement dead zone, during different sampling window time periods, the three-phase current of the motor can be restored by measuring the voltage and the current, and the switch-on current, the on-tube voltage drop, and the off-tube voltage drop of the lower tube of each phase bridge arm can be obtained simultaneously. As a result, the switch-on resistance of the lower tube can be easily obtained based on the switch-on current and the on-tube voltage drop. Then, the three-phase current of the motor in the current measurement dead zone can be obtained based on the switch-on resistance. At last, the three-phase feedback current of the motor can be obtained, and the three-phase output line voltage and the direct-current bus voltage can be obtained based on the off-tube voltage drop.

As a second example, outside the current measurement dead zone, during the first sampling window time period, the on-tube voltage drop when the lower tube of each phase bridge arm is switched on can be obtained; during the second sampling window time period, the V-phase current, the on-tube voltage drop of the lower tube of the U-phase bridge arm, and the on-tube voltage drop of the lower tube of the W-phase bridge arm, and the off-tube voltage drop of the lower tube of the V-phase bridge arm are obtained; during the third sampling window time period, the U-phase current, the on-tube voltage drop of the lower tube of the U-phase bridge arm, the off-tube voltage drop of the lower tube of the V-phase bridge arm, and the off-tube voltage drop of the lower tube of the W-phase bridge arm are obtained, or the W-phase current, the on-tube voltage drop of the lower tube of the W-phase bridge arm, the off-tube voltage drop of the lower tube of the U-phase bridge arm, and the off-tube voltage drop of the lower tube of the V-phase bridge arm are obtained; and during the fourth sampling window time period, the off-tube voltage drop of the lower tube of each phase bridge arm when the lower tube of each phase bridge arm is switched off can be obtained.

As a third example, outside the current measurement dead zone, during the first sampling window time period, the on-tube voltage drop when the lower tube of each phase bridge arm is switched on can be obtained; during the second sampling window time period, the W-phase current, the on-tube voltage drop of the lower tube of the U-phase bridge arm, the on-tube voltage drop of the lower tube of the V-phase bridge arm, and the off-tube voltage drop of the lower tube of the W-phase bridge arm are obtained; during the third sampling window time period, the U-phase current, the on-tube voltage drop of the lower tube of the U-phase bridge arm, the off-tube voltage drop of the lower tube of the V-phase bridge arm, and the off-tube voltage drop of the lower tube of the W-phase bridge arm are obtained, or the V-phase current, the on-tube voltage drop of the lower tube of the V-phase bridge arm, the off-tube voltage drop of the lower tube of the U-phase bridge arm, and the off-tube voltage drop of the lower tube of the W-phase bridge arm are obtained; and during the fourth sampling window time period, the off-tube voltage drop of the lower tube of each phase bridge arm when the lower tube of each phase bridge arm is switched off can be obtained.

It should be noted that the second example is to sample the phase current, the on-tube voltage drop of the lower tube, and the off-tube voltage drop of the lower tube when the first activated upper tube is the upper tube of the V-phase and the last activated upper tube is the upper tube of the U-phase or the upper tube of the W-phase. The third example is to sample the phase current, the on-tube voltage drop of the lower tube, and the off-tube voltage drop of the lower tube when the first activated upper tube is the upper tube of the W-phase and the last activated upper tube is the upper tube of the U-phase or the upper tube of the V-phase. The sampling principle is similar to that of the example illustrated in FIG. 4, and details thereof can refer to FIG. 4, and are not repeated herein. Table 1 shows a relation between sectors where different voltage vectors are located, the phase current corresponding to the direct-current bus current, and the on-tube voltage drop and the off-tube voltage drop of the lower tube that can be sampled.

Table 1

| UH | VH | WH | Idc | the on-tube voltage drop of the lower tube can be sampled. | the off-tube voltage drop of the lower tube can be sampled. |
|---|---|---|---|---|---|
| 1 | 0 | 0 | Iu | Vdsv_on<br>Vdsw_on | Vdsu_off |
| 0 | 1 | 0 | Iv | Vdsu_on<br>Vdsw_on | Vdsv_off |
| 0 | 0 | 1 | Iw | Vdsu_on<br>Vdsv_on | Vdsw_off |
| 0 | 1 | 1 | -Iu | Vdsu_on | Vdsv_off<br>Vdsw_off |
| 1 | 0 | 1 | -Iv | Vdsv_on | Vdsu_off<br>Vdsw_off |
| 1 | 1 | 0 | -Iw | Vdsw_on | Vdsu_off<br>Vdsv_off |
| 0 | 0 | 0 | 0 | Vdsu_on<br>Vdsv_on<br>Vdsw_on | 0 |

(continued)

| UH | VH | WH | Idc | the on-tube voltage drop of the lower tube can be sampled. | the off-tube voltage drop of the lower tube can be sampled. |
|---|---|---|---|---|---|
| 1 | 1 | 1 | 0 | 0 | Vdsu_off<br>Vdsv_off<br>Vdsw_off |

In Table 1, UH represents a condition where the upper tube of the U-phase bridge arm is switched on, VH represents a condition where the upper tube of the V-phase bridge arm is switched on, WH represents a condition where the upper tube of the W-phase bridge arm is switched on, "1" represents switch on, "0" represents switch off, Idc represents the direct-current bus current, Iu represents the U-phase current, Iv represents the V-phase current, Iw represents the W-phase current, Vdsu_on represents the on-tube voltage drop of the lower tube of the U-phase bridge arm, Vdsv_on represents the on-tube voltage drop of the lower tube of the V-phase bridge arm, Vdsw_on represents the on-tube voltage drop of the lower tube of the W-phase bridge arm, Vdsu_off represents the off-tube voltage drop of the lower tube of the U-phase bridge arm, Vdsv_off represents the off-tube voltage drop of the lower tube of the V-phase bridge arm, and Vdsw_off represents the off-tube voltage drop of the lower tube of W-phase bridge arm.

It should be noted that in the above example, outside the current measurement dead zone, because the sampling window time periods Ts2 and Ts3 are enough to complete the current sampling, the three-phase current of the motor can be restored based on the measured two-phase current. While inside the current measurement dead zone, because the sampling window time period Ts2 or Ts3 is too short to complete the current sampling, the two-phase current of the three-phase current cannot be measured, and thus the three-phase current of the motor cannot be restored. In this case, the switch-on current of the lower tube of each phase can be obtained based on the three-phase current outside the current measurement dead zone, and the switch-on resistance can be calculated based on the on-tube voltage drop of the lower tube of each phase outside the current measurement dead zone. Then, inside the current measurement dead zone, the on-tube voltage drops of the lower tubes of at least two phases is sampled instead of sampling the current. Then, the switch-on currents of the lower tubes of at least two phases inside the current measurement dead zone are calculated based on the on-tube voltage drop inside the current measurement dead zone and the calculated switch-on resistance of the lower tube. As a result, the three-phase current of the motor (when only the two phase currents are calculated, the third phase current can be calculated based on the zero sum of the currents) is obtained. As such, the three-phase current inside the current measurement dead zone is obtained. The three-phase output line voltage and the direct-current bus voltage can be obtained outside and inside the current measurement dead zone.

For ease of understanding, the following describes an obtaining process of the three-phase feedback current, the three-phase output line voltage, and the direct-current bus voltage of the motor with a specific example.

In an embodiment, as illustrated in FIG. 4, four sampling window time periods Ts1, Ts2, Ts3, and Ts4 are first calculated based on a switch-on time sequence, where Ts1=Ta-T, Ta represents a time point when the upper tube VT1 of the U-phase bridge arm is switched on, and since the sampling window time period is timed by another timer (a counting pulse of the timer can have a consistent frequency with a PWM pulse), an initial time period T=0, Ts1=Ta; Ts2=Tb-Ta-Tdelay, Tb represents a time point when the upper tube VT3 of the V-phase bridge arm is switched on, and Tdelay represents a first predetermined time period; Ts3=Tc-Tb-Tdelay, Tc represents a time point when the upper tube VT5 of the W-phase bridge arm is switched on; and Ts4=Tc'-T, Tc' represents a time point when the upper tube VT5 of the W-phase bridge arm is switched off, an initial time period T=0, and therefore Ts4=Tc'.

Then, the sampling window time periods Ts2 and Ts3 are determined. If the sampling window time periods Ts2 and Ts3 each are greater than or equal to a minimum current sampling time period tmin, it means that it is currently outside the current measurement dead zone illustrated in FIG. 3, while if at least one of the sampling window time periods Ts2 and Ts3 is smaller than the minimum current sampling time period tmin, it means that it is currently inside the current measurement dead zone illustrated in FIG. 3. It should be noted that whether it is inside the current measurement dead zone can be determined based on lengths of two adjacent non-zero voltage vectors.

Assuming that it is outside the current measurement dead zone in a first carrier cycle illustrated in FIG. 4, the current sampling is performed in this case, the three-phase current of the motor is restored based on a current sampling result, and the three-phase output line voltage and the direct-current bus voltage are obtained simultaneously. In an embodiment, when the timer of the triangular waveform has underflow interrupt, that is, PWM underflow interrupt begins. In this case, it enters the first sampling window time period Ts1. At this case, a timing time period of the sampling timer is set to Ta+Tdelay, and the sampling timer is started. At the same time, the sampling of the on-tube voltage drop of the lower tube is started to sample the on-tube voltage drops of one or more lower tubes. For example, the on-tube voltage drops Vdsu_on, Vdsv_on, and Vdsw_on are obtained by sampling the on-tube voltage drops of the lower tubes VT4, VT6, and VT2, and are stored. When the timing time period of the sampling timer reaches Ta+Tdelay, it enters the second sampling window time period Ts2. In this case, a timing time period of the sampling timer is set to Ts2+Tdelay, and the sampling timer is started. At the same time, the on-tube voltage drops Vdsv_on and Vdsw_on of the lower tubes VT6 and VT2, the off-tube voltage drop Vdsu_off of the lower tube VT4, and the U-phase current Iu are obtained by starting the sampling of the on-tube voltage drops of the lower tube VT6 and VT2, the sampling of the off-tube voltage drop of the lower tube VT4, and the sampling of the direct-current bus current Idc, and are stored. When the timing time period of the sampling timer reaches Ts2+Tdelay, it enters the third sampling window time period Ts3. In this case, and the on-tube voltage drop Vdsw_on of the lower tube VT2, the off-tube voltage drops Vdsu_off and Vdsv_off of the lower tubes VT4 and VT6, and the W-phase current Iw are obtained by starting the sampling of the on-tube voltage drop of the lower tube VT2, the sampling of the off-tube voltage drops of the lower tubes VT4 and VT6, and the sampling of the direct-current bus current Idc, and are stored. When the timer of the triangular waveform has the overflow interrupt, that is, the PWM overflow interrupt starts, it enters the fourth sampling window time period Ts4, and the sampling of the off-tube voltage drop of the lower tube is started to sample the off-tube voltage drop of one or more lower tubes. For example, the off-tube voltage drops Vdsu_off, Vdsv_off, and Vdsw_off are obtained by sampling the off-tube voltage drops of the lower tubes VT4, VT6, and VT2, and are stored. Up to this point, the sampling of one carrier cycle has been completed.

Then, the V-phase current Iv can be calculated based on Iu+Iv+Iw=0, and thus the three-phase currents Iu, Iv, and Iw of the motor outside the current measurement dead zone are obtained. The switch-on current of the lower tube can be obtained based on the relation between the three-phase currents of the motor and the switch-on currents of the lower tubes, that is, the switch-on currents of the lower tubes are Iu, Iv, and Iw respectively. Then, the switch-on resistance of each lower tube is calculated by the above formula (1) based on the switch-on currents of the lower tubes and the on-tube voltage drops Vdsu_on, Vdsv_on, and Vdsw_on of the lower tubes, and are stored. At the same time, the three-phase output line voltages Vuv, Vvw, and Vwu of the motor and the direct-current bus voltage Vdc of the motor are obtained by the above formulas (4) and (5) based on the off-tube voltage drops Vdsu_off, Vdsv_off, and Vdsw_off of the lower tubes, and are stored.

Then, it enters a next carrier cycle, assuming that the next carrier cycle is inside the current measurement dead zone, then the current sampling is not performed in this case, but the three-phase current of the motor inside the current measurement dead zone is obtained based on the switch-on resistance of the lower tube of each phase obtained before, and the three-phase output line voltage and the direct-current bus voltage are obtained simultaneously. In an embodiment, when the timer of triangular waveform has the underflow interrupt, that is, the PWM underflow interrupt starts, it enters the first sampling window time period Ts1. In this case, the timing time period of the sampling timer is set to Ta+Tdelay, and the sampling timer is started. At the same time, the sampling of the on-tube voltage drop of the lower tube is started to sample the on-tube voltage drops of one or more lower tubes. For example, the on-tube voltage drop Vdsu_on (assuming that the first sampling window time period Ts1 is short, only one on-tube voltage drop of the lower tube can be sampled) is obtained by sampling the on-tube voltage drop of the lower tube Vt4, and is stored. When the timing time period of the sampling timer reaches Ta+Tdelay, it enters the second sampling window time period Ts2. In this case, a timing time period of the sampling timer is set to Ts2+Tdelay, and the sampling timer is started. At the same time, the on-tube voltage drops Vdsv_on and Vdsw_on of the lower tubes VT6 and VT2 and the off-tube Vdsu_off of the lower tube VT4 are obtained by sampling the on-tube voltage drops of the lower tubes VT6 and VT2 and the off-tube of the lower tube VT4 (assuming that the second sampling window time period Ts2 is long), and are stored. When the timing time period of the sampling timer reaches Ts2+Tdelay, it enters the third sampling window time period Ts3. Because the third sampling window time period Ts3 is short (assuming that the third sampling window time period Ts3 is smaller than the minimum current sampling time tmin), no sampling is performed in this case. When the timer of the triangular waveform has the overflow interrupt, that is, the PWM overflow interrupt starts, it enters the fourth sampling window time period Ts4, and the sampling of the off-tube voltage drop of the lower tube is started to sample the off-tube voltage drops of one or more lower tubes. For example, the off-tube voltage drops Vdsu_off, Vdsv_off, and Vdsw_off are obtained by sampling the off-tube voltage drops of the lower tubes VT4, VT6, and VT2 (assuming that the fourth sampling window time period Ts4 is long), and are stored. Up to this point, the sampling of one carrier cycle has been completed.

Then, the switch-on currents of the lower tubes, that is, the three-phase currents Iu', Iv', and Iw' of the motor, are calculated by the above formula (2) based on the on-tube voltage drops Vdsu_on, Vdsv_on, and Vdsw_on of the lower tubes and the switch-on resistances of the corresponding lower tubes calculated at the end of the first carrier cycle. It should be noted that a ratio between the standard switch-on resistance of the switching tube and the calculated switch-on resistance can also be calculated at the end of the first carrier cycle, and then at the end of this carrier cycle, the initial three-phase current can be calculated based on the on-tube voltage drops Vdsu_on, Vdsv_on, and Vdsw_on of the lower tubes and the standard switch-on resistance, and then the three-phase currents Iu', Iv' and Iw' of the motor can be obtained by correcting the initial three-phase current using the ratio. At the same time, the three-phase output line voltages Vuv, Vvw, and Vwu of the motor and the direct-current bus voltage Vdc are obtained by the above formulas (4) and (5) based on the off-tube voltage drops Vdsu_off, Vdsv_off, and Vdsw_off of the lower tubes, and are stored.

Then, it enters a next carrier cycle, and the above process is repeated. A complete three-phase current is obtained as the three-phase feedback current of the motor by synthesizing the obtained three-phase currents Iu, Iv, and Iw outside the current measurement dead zone with the three-phase currents Iu', Iv', and Iw' inside the current measurement dead zone, and is stored, in order to control the motor based on the three-phase feedback current, such as Field Oriented Control (FOC, that is, voltage vector control) current loop control. At the same time, the motor is controlled based on the three-phase output line voltages Vuv, Vvw, and Vwu and the direct-current bus voltage Vdc. For example, the magnetic flux linkage observer is estimated using the three-phase output line voltages Vuv, Vvw, and Vwu, and a voltage vector width and a switch-on time period of PWM are calculated using the direct-current bus voltage Vdc when the voltage is output through space vector pulse width modulation (SVPWM).

In the above embodiment, the current time-sharing sampling technology is used to correct the deviation problem of the switching tube due to temperature changes when using the internal resistance of the switching tube to perform the current measurement and restoration, and also realizes the measurement sharing of a plurality of input voltage variables during the FOC calculation process. On the one hand, the harmonics of the single-resistor sampling current and the motor noise are avoided. On the other hand, the voltage sampling circuit is reduced. In this way, the multi-purpose is realized, which has high engineering application value.

It should be noted that in order to comprehensively protect each switching tube, in the above example, the corresponding voltage sampling unit is set for each lower tube, and the voltage sampling unit is used to sample the tube voltage drop of the lower tube, but the sampling form is not limited to sampling the tube voltage drop of all the lower tube, and all results can be inferred based on the symmetry principle by sampling the tube voltage drop of one lower tube or two lower tubes to reduce the cost.

To sum up, according to the single-resistor measurement method of the embodiment of the present disclosure, the current inside the current measurement dead zone is obtained or corrected by real-time sampling the on-tube voltage drop of the lower tube when three-phase current is obtained by the single-resistor sampling. At the same time, the three-phase output line voltage and the direct-current bus voltage are obtained by real-time sampling the off-tube voltage drop of the lower tube through the staggered time sequence. Therefore, by sharing the tube voltage drop sampling circuit of the lower tube, the current sampling error is improved. Moreover, when the motor is controlled based on the three-phase output line voltage, the problem of voltage error input by the magnetic flux linkage observer can be solved. In this way, the multi-purpose is truly realized, and the method is simple and easy to realize engineering application.

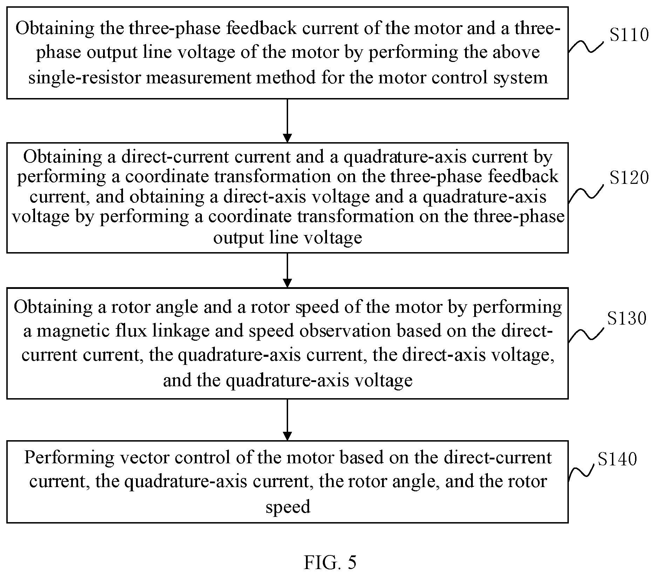

FIG. 5 is a schematic flowchart of a motor control method according to an embodiment of the present disclosure. Referring to FIG. 5, the motor control method may include actions at steps S110 to S140.

At step S110, the three-phase feedback current of the motor and a three-phase output line voltage of the motor are obtained by performing the aforementioned single-resistor measurement method for the motor control system.

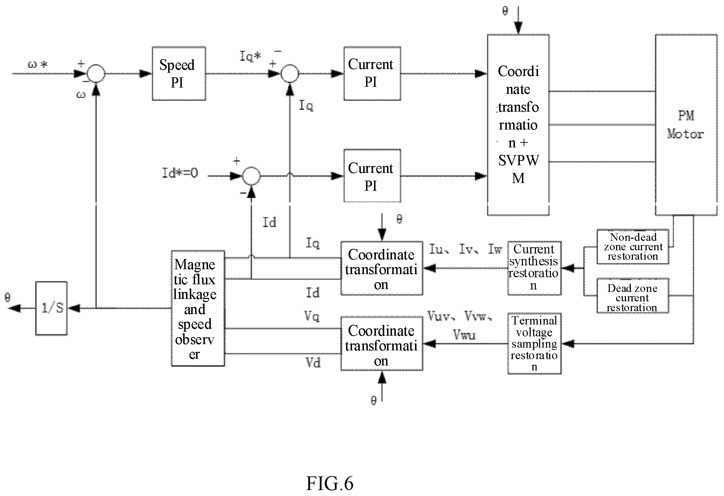

In an embodiment, as illustrated in FIG. 6, in the process of controlling the motor, based on the aforementioned single-resistor measurement method, the three-phase current of the motor outside the current measurement dead zone can be obtained through a non-dead zone current restoration module, and the three-phase current of the motor inside the current measurement dead zone can be obtained through a dead zone current restoration module, and the three-phase feedback currents Iu, Iv, and Iw of the motor can be obtained by synthesizing the three-phase currents outside and inside the current measurement dead zone through a current synthesis restoration module. At the same time, based on the single-resistor measurement method mentioned above, the three-phase output line voltages Vuv, Vvw, and Vwu of the motor are obtained through a terminal voltage sampling restoration unit. For the specific process, reference can be made to the above description of the single-resistor measurement method, which will not be repeated herein.

At step S120, a direct-current current and a quadrature-axis current are obtained by performing a coordinate transformation to the three-phase feedback current, and a direct-axis voltage and a quadrature-axis voltage are obtained by performing a coordinate transformation to the three-phase output line voltage.

In an embodiment, as illustrated in FIG. 6, the three-phase feedback currents Iu, Iv, and Iw can be subjected to the coordinate transformation through a coordinate transformation module to generate a direct-current current Id and a quadrature-axis current Iq. The direct-current current Id and the quadrature-axis current Iq are stored. At the same time, the three-phase output line voltages Vuv, Vvw, and Vwu can be subjected to the coordinate transformation through a coordinate transformation module to generate a direct axis voltage Vd and a quadrature axis voltage Vq. The direct axis voltage Vd and the quadrature axis voltage Vq are stored.

At step S130, a rotor angle and a rotor speed of the motor are obtained by performing a magnetic flux linkage and speed observation based on the direct-current current, the quadrature-axis current, the direct-axis voltage, and the quadrature-axis voltage.

In an embodiment of the present disclosure, as illustrated in FIG. 6, the direct-current current Id, the quadrature-axis current Iq, the direct-axis voltage Vd, and the quadrature-axis voltage Vq can be input into the magnetic flux linkage and speed observer, and the magnetic flux linkage and speed can be calculated without a position sensor, and the rotor speed $\omega$ can thus be obtained, and the rotor speed $\omega$ can be converted into the rotor angle $\theta$ of the motor by using an integration module. This rotor angle $\theta$ can be configured for coordinate transformation and PWM signal generation.

At step S140, vector control of the motor is performed based on the direct-current current, the quadrature-axis current, the rotor angle, and the rotor speed.

In an embodiment, as illustrated in FIG. 6, a difference between a given rotor speed ω* and the rotor speed ω can be calculated first, and a given quadrature-axis current Iq* can be obtained by PI adjustment of the difference through a speed loop PI controller. Then, a difference between the given quadrature-axis current Iq* and the quadrature-axis current Iq can be calculated, and a given quadrature-axis voltage can be obtained by the PI adjustment through a magnetic flux linkage current loop PI controller. At the same time, a difference between a given direct-axis current Id* and the direct-axis current Id is calculated, and a given direct-axis voltage is obtained by the PI adjustment through a torque current loop PI controller. Then, the motor is controlled by generating a PWM signal through the coordinate transformation and the SVPWM control module based on the given quadrature-axis voltage, the given direct-axis voltage, and the rotor angle θ.

In some embodiments of the present disclosure, the direct-current bus voltage is also obtained based on the aforementioned single-resistor measurement method, and the motor is controlled by generating the PWM signal through the coordinate transformation and the SVPWM control module based on the direct-current bus voltage, the given quadrature-axis voltage, the given direct-axis voltage, and the rotor angle θ.

In the above embodiment, based on the aforementioned single-resistor measurement method, the three-phase feedback current of the motor is effectively restored by obtaining the three-phase current outside the dead zone based on the single-resistor sampling and obtaining the three-phase current inside the dead zone based on the on-tube voltage drop and the switch-on resistance when the lower tube is switched on, and there is no need to perform the PWM phase shift, effectively avoiding the problem of the increase in the motor noise caused by the PWM phase shift for the current measurement in the dead zone. Meanwhile, using the single resistor for the current sampling avoids problems of the high current sampling cost and the introduction of additional power consumption caused by using the plurality of resistors for the current sampling. At the same time, the three-phase output line voltage is obtained based on the off-tube voltage drop of the lower tube, which effectively solves a problem of a significant discrepancy between the actual voltage and an estimated voltage caused by an estimation of a magnetic flux linkage and speed observer using an internally calculated command voltage during the vector control, which in turn causes a problem of control performance degradation such as low speed control accuracy and a small speed control range. In this way, a lower speed limit range and control accuracy of speed control are effectively improved. At the same time, the direct-current bus voltage can be obtained based on the off-tube voltage drop of the lower tube, and the voltage vector pulse width and the switch-on time period can be calculated based on the direct-current bus voltage. As a result, no direct-current bus voltage measurement unit is required, which effectively reduces the cost and the space occupation.

In some embodiments of the present disclosure, there is also provided a motor controller. The motor controller includes a memory, a processor, and a single-resistor measurement program for a motor control system stored on the memory and executable on the processor. The processor is configured to, when running the single-resistor measurement program, implement the aforementioned single-resistor measurement method for the motor control system.

According to the motor controller of the embodiment of the present disclosure, based on the aforementioned single-resistor measurement method, the current inside the current measurement dead zone is obtained or corrected by real-time sampling the on-tube voltage drop of the lower tube when three-phase current is obtained by the single-resistor sampling. At the same time, the three-phase output line voltage and the direct-current bus voltage are obtained by real-time sampling the off-tube voltage drop of the lower tube through the staggered time sequence. Therefore, by sharing the tube voltage drop sampling circuit of the lower tube, not only the current sampling error is improved, but also the problem of voltage error input by the magnetic flux linkage observer can be solved. In this way, the multi-purpose is truly realized, and the method is simple and easy to realize the engineering application.

In some embodiments of the present disclosure, there is also provided a computer-readable storage medium. The computer-readable storage medium has a single-resistor measurement program for a motor control system stored thereon. The single-resistor measurement program for the motor control system is configured to, when executed by a processor, implement the aforementioned single-resistor measurement method for the motor control system.

According to the computer-readable storage medium of the embodiment of the present disclosure, based on the aforementioned single-resistor measurement method, the current inside the current measurement dead zone is obtained or corrected by real-time sampling the on-tube voltage drop of the lower tube when three-phase current is obtained by the single-resistor sampling. At the same time, the three-phase output line voltage and the direct-current bus voltage are obtained by real-time sampling the off-tube voltage drop of the lower tube through the staggered time sequence. Therefore, by sharing the tube voltage drop sampling circuit of the lower tube, not only the current sampling error is improved, but also the problem of voltage error input by the magnetic flux linkage observer can be solved. In this way, the multi-purpose is truly realized, and the method is simple and easy to realize the engineering application.

In some embodiments of the present disclosure, there is also provided a motor control system. Referring to FIG. 1, the motor control system includes a motor (not specifically illustrated in the FIG. 1), a three-phase inverter bridge 10, a current measurement unit 20, a first voltage measurement unit 30, a second voltage measurement unit 40, a third voltage measurement unit 50, and a control unit (not specifically illustrated in the FIG. 1).

The three-phase inverter bridge 10 is connected between direct-current buses and configured to drive the motor to operate. The current measurement unit 20 includes a single sampling resistor R arranged corresponding to a negative

16

pole of the direct-current bus and configured to measure a direct-current bus current. The first voltage measurement unit 30 corresponds to a lower tube of a U-phase bridge arm in the three-phase inverter bridge 10 and is configured to measure a lower tube voltage drop of the U-phase bridge arm. The second voltage measurement unit 40 corresponds to a lower tube of a V-phase bridge arm in the three-phase inverter bridge 10 and is configured to measure a lower tube voltage drop of the V-phase bridge arm. The third voltage measurement unit 50 corresponds to a lower tube of a W-phase bridge arm in the three-phase inverter bridge 10 and is configured to measure a lower tube voltage drop of the W-phase bridge arm. The control unit is configured to: determine, based on the direct-current bus current, a switch-on current when a lower tube of at least one phase bridge arm in the three-phase inverter bridge is switched on; obtain an on-tube voltage drop when the lower tube of the at least one phase bridge arm in the three-phase inverter bridge is switched on; determine, based on the switch-on current and the on-tube voltage drop when the lower tube of the at least one phase bridge arm in the three-phase inverter bridge is switched on, a switch-on resistance when the lower tube of the at least one phase bridge arm in the three-phase inverter bridge is switched on; determine, based on the direct-current bus current, a three-phase current outside a current measurement dead zone; and determine, based on the on-tube voltage drop and the switch-on resistance, a three-phase current inside the current measurement dead zone. The control unit is further configured to determine, based on the three-phase current outside the current measurement dead zone and the three-phase current inside the current measurement dead zone, a three-phase feedback current of the motor.

In some embodiments of the present disclosure, the control unit is further configured to: obtain an off-tube voltage drop when the lower tube of the at least one phase bridge arm in the three-phase inverter bridge is switched off; and determine, based on the off-tube voltage drop, a three-phase output line voltage of the motor and a direct-current bus voltage of the motor.

In some embodiments of the present disclosure, the control unit is further configured to: obtain a direct-current current and a quadrature-axis current by performing a coordinate transformation to the three-phase feedback current, and obtain a direct-axis voltage and a quadrature-axis voltage by performing a coordinate transformation to the three-phase output line voltage; obtain a rotor angle and a rotor speed of the motor by performing a magnetic flux linkage and speed observation based on the direct-current current, the quadrature-axis current, the direct-axis voltage, and the quadrature-axis voltage; and perform vector control of the motor based on the direct-current current, the quadrature-axis current, the rotor angle, and the rotor speed.

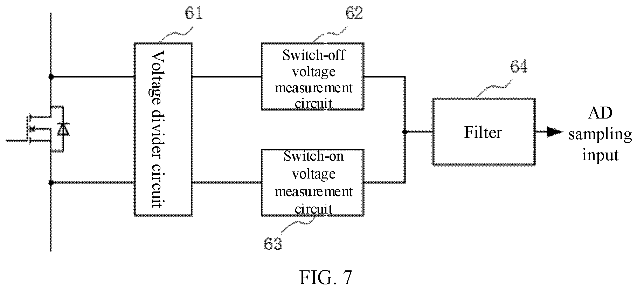

In some embodiments of the present disclosure, the first voltage measurement unit 30, the second voltage measurement unit 40, and the third voltage measurement unit 50 have the same structure, as illustrated in FIG. 7, and specifically include a voltage divider circuit 61, a switch-off voltage measurement circuit 62, a switch-on voltage measurement circuit 63, and a filter 64. The switch-off voltage measurement circuit 62 has a switch-off voltage measurement capability. The switch-on voltage measurement circuit 63 has a switch-on voltage measurement capability. The switch-off voltage measurement circuit 62 and the switch-on voltage measurement circuit 63 share the voltage divider circuit 61 and the filter 64. As such, the use of circuit devices can be greatly reduced, which helps to reduce the cost and the space occupation.

It should be noted that for the description of other contents of the motor control system, reference can be made to the aforementioned single-resistor measurement method and the motor control method, and details thereof are not be repeated herein.

It should be noted that the logic and/or step described in other manners herein or shown in the flow chart, for example, a particular sequence table of executable instructions for realizing the logical function, may be specifically achieved in any computer-readable medium to be used by the instruction execution system, device or equipment (such as the system based on computers, the system including processors or other systems capable of obtaining the instruction from the instruction execution system, device and equipment and executing the instruction), or to be used in combination with the instruction execution system, device and equipment. As to the specification, "the computer-readable medium" may be any device adaptive for including, storing, communicating, propagating or transferring programs to be used by or in combination with the instruction execution system, device or equipment. More specific examples of the computer-readable medium include but are not limited to: an electronic connection (an electronic device) with one or more wires, a portable computer enclosure (a magnetic device), a random access memory (RAM), a read only memory (ROM), an erasable programmable read-only memory (EPROM or a flash memory), an optical fiber device and a portable compact disk read-only memory (CDROM). In addition, the computer-readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the present disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array (PGA), a field programmable gate array (FPGA), etc.

Reference throughout this specification to "an embodiment," "some embodiments," "an example," "a specific example," or "some examples," means that a particular feature, structure, material, or characteristic described in connection with the embodiment or example is included in at least one embodiment or example of the present disclosure. The appearances of the above phrases in various places throughout this specification are not necessarily referring to the same embodiment or example of the present disclosure. Furthermore, the particular features, structures, materials, or characteristics may be combined in any suitable manner in one or more embodiments or examples.

In addition, terms such as "first" and "second" are used herein for purposes of description and are not intended to indicate or imply relative importance, or to implicitly show the number of technical features indicated. Thus, the feature defined with "first" and "second" may explicitly or implicitly include one or more this feature. In the description of the present disclosure, "a plurality of" means at least two, for example, two or three, unless specified otherwise.

In the present disclosure, unless specified or limited otherwise, the terms "mounted," "connected," "coupled" and "fixed" are understood broadly, such as fixed, detachable mountings, connections and couplings or integrated, and can be mechanical or electrical mountings, connections and couplings, and also can be direct and via media indirect mountings, connections, and couplings, and further can be inner mountings, connections and couplings of two components or interaction relations between two components, which can be understood by those skilled in the art according to the detail embodiment of the present disclosure.

Although embodiments of present disclosure have been shown and described above, it should be understood that above embodiments are just explanatory, and cannot be construed to limit the present disclosure which is defined by the appended claims.

## Claims

1. A single-resistor measurement method for a motor control system, the motor control system comprising a three-phase inverter bridge and a single sampling resistor corresponding to a negative pole of a direct-current bus, the three-phase inverter bridge being configured to drive a motor to operate, the method comprising:

   (S10) obtaining a direct-current bus current flowing through the single sampling resistor, and determining, based on the direct-current bus current, a switch-on current when a lower tube of at least one phase bridge arm in the three-phase inverter bridge is switched on;
   (S20) obtaining an on-tube voltage drop when the lower tube of the at least one phase bridge arm in the three-phase inverter bridge is switched on;

   **characterised in that** the method further comprises:

   (S30) determining, based on the switch-on current and the on-tube voltage drop when the lower tube of the at least one phase bridge arm in the three-phase inverter bridge is switched on, a switch-on resistance when the lower tube of the at least one phase bridge arm in the three-phase inverter bridge is switched on; and
   (S40) determining, based on the direct-current bus current, a three-phase current outside a current measurement dead zone; determining, based on the on-tube voltage drop and the switch-on resistance, a three-phase current inside the current measurement dead zone; and determining, based on the three-phase current outside the current measurement dead zone and the three-phase current inside the current measurement dead zone, a three-phase feedback current of the motor.

2. The method according to claim 1, further comprising:

   obtaining an off-tube voltage drop when the lower tube of the at least one phase bridge arm in the three-phase inverter bridge is switched off; and
   determining, based on the off-tube voltage drop, a three-phase output line voltage of the motor and a direct-current bus voltage of the motor.

3. The method according to claim 2, further comprising, prior to said obtaining the direct-current bus current and the on-tube voltage drop:
   determining a first sampling window time period, a second sampling window time period, and a third sampling window time period, wherein:

the first sampling window time period is a time period starting from a time point of underflow interrupt of a PWM triangular waveform to a time point when an upper tube of any phase bridge arm in the three-phase inverter bridge is switched on;

the second sampling window time period is a time period starting from a time point when the upper tube of any phase bridge arm in the three-phase inverter bridge is switched on and delayed for a first predetermined time period, to a time point when an upper tube of a next phase bridge arm in the three-phase inverter bridge is switched on; and

the third sampling window time period is a time period starting from a time point when the upper tube of the next phase bridge arm in the three-phase inverter bridge is switched on and delayed for the first predetermined time period, to a time point when an upper tube of a last phase bridge arm in the three-phase inverter bridge is switched on.

4. The method according to claim 3, wherein said determining, based on the direct-current bus current, the switch-on current when the lower tube of the at least one phase bridge arm in the three-phase inverter bridge is switched on comprises:

obtaining a phase current of the motor by sampling the direct-current bus current during the second sampling window time period and the third sampling window time period; and

determining, based on the phase current of the motor, the switch-on current when the lower tube of the at least one phase bridge arm in the three-phase inverter bridge is switched on.

5. The method according to claim 3, wherein said (S20) obtaining the on-tube voltage drop when the lower tube of the at least one phase bridge arm in the three-phase inverter bridge is switched on comprises:
obtaining the on-tube voltage drop when the lower tube of the at least one phase bridge arm in the three-phase inverter bridge is switched on by sampling on-tube voltage drops during at least one of the first sampling window time period, the second sampling window time period, and the third sampling window time period.

6. The method according to claim 2, further comprising, prior to said obtaining the off-tube voltage drop:
determining, based on a time sequence of switching tubes to be switched on in the three-phase inverter bridge, a fourth sampling window time period, wherein the fourth sampling window time period is a time period starting from a time point of overflow interrupt of a PWM triangular waveform to a time point when an upper tube of any phase bridge arm in the three-phase inverter bridge is switched off.

7. The method according to claim 6, wherein said obtaining the off-tube voltage drop when the lower tube of the at least one phase bridge arm in the three-phase inverter bridge is switched off comprises:
obtaining the off-tube voltage drop when the lower tube of the at least one phase bridge arm in the three-phase inverter bridge is switched off by sampling off-tube voltage drops during at least one of the second sampling window time period, the third sampling window time period, and the fourth sampling window time period.

8. A motor control method, comprising:

(S110) obtaining the three-phase feedback current of the motor and a three-phase output line voltage of the motor by performing a single-resistor measurement method for the motor control system according to any one of claims 1 to 7;

(S120) obtaining a direct-current current and a quadrature-axis current by performing a coordinate transformation to the three-phase feedback current, and obtaining a direct-axis voltage and a quadrature-axis voltage by performing a coordinate transformation to the three-phase output line voltage;

(S130) obtaining a rotor angle and a rotor speed of the motor by performing a magnetic flux linkage and speed observation based on the direct-current current, the quadrature-axis current, the direct-axis voltage, and the quadrature-axis voltage; and

(S140) performing vector control of the motor based on the direct-current current, the quadrature-axis current, the rotor angle, and the rotor speed.

9. A motor controller, comprising:

a memory;
a processor; and
a single-resistor measurement program for a motor control system stored on the memory and executable on the processor,

wherein the processor is configured to, when running the single-resistor measurement program, implement a single-resistor measurement method for the motor control system according to any one of claims 1 to 7.

10. A computer readable storage medium, having a single-resistor measurement program for a motor control system stored thereon, the single-resistor measurement program for the motor control system being configured to, when executed by a processor, implement a single-resistor measurement method for the motor control system according to any one of claims 1 to 7.

11. A motor control system, comprising:

a motor;
a three-phase inverter bridge (10) connected between direct-current buses and configured to drive the motor to operate;
a current measurement unit (20) comprising a single sampling resistor, the single sampling resistor is arranged corresponding to a negative pole of the direct-current bus and configured to measure a direct-current bus current;
a first voltage measurement unit (30) arranged corresponding to a lower tube of a U-phase bridge arm in the three-phase inverter bridge (10) and configured to measure a lower tube voltage drop of the U-phase bridge arm;
a second voltage measurement unit (40) arranged corresponding to a lower tube of a V-phase bridge arm in the three-phase inverter bridge (10) and configured to measure a lower tube voltage drop of the V-phase bridge arm;
a third voltage measurement unit (50) arranged corresponding to a lower tube of a W-phase bridge arm in the three-phase inverter bridge (10) and configured to measure a lower tube voltage drop of the W-phase bridge arm;
a control unit configured to:

determine, based on the direct-current bus current, a switch-on current when a lower tube of at least one phase bridge arm in the three-phase inverter bridge (10) is switched on,
obtain an on-tube voltage drop when the lower tube of the at least one phase bridge arm in the three-phase inverter bridge (10) is switched on,
determine, based on the switch-on current and the on-tube voltage drop when the lower tube of the at least one phase bridge arm in the three-phase inverter bridge (10) is switched on, a switch-on resistance when the lower tube of the at least one phase bridge arm in the three-phase inverter bridge (10) is switched on,
determine, based on the direct-current bus current, a three-phase current outside a current measurement dead zone, and
determine, based on the on-tube voltage drop and the switch-on resistance, a three-phase current inside the current measurement dead zone,
wherein the control unit is further configured to determine, based on the three-phase current outside the current measurement dead zone and the three-phase current inside the current measurement dead zone, a three-phase feedback current of the motor.

12. The motor control system according to claim 11, wherein the control unit is further configured to:

obtain an off-tube voltage drop when the lower tube of the at least one phase bridge arm in the three-phase inverter bridge (10) is switched off; and
determine, based on the off-tube voltage drop, a three-phase output line voltage of the motor and a direct-current bus voltage of the motor.

13. The motor control system according to claim 12, wherein the control unit is further configured to:

obtain a direct-current current and a quadrature-axis current by performing a coordinate transformation to the three-phase feedback current, and obtain a direct-axis voltage and a quadrature-axis voltage by performing a coordinate transformation to the three-phase output line voltage;
obtain a rotor angle and a rotor speed of the motor by performing a magnetic flux linkage and speed observation based on the direct-current current, the quadrature-axis current, the direct-axis voltage, and the quadrature-axis voltage; and
perform vector control of the motor based on the direct-current current, the quadrature-axis current, the rotor angle, and the rotor speed.

**Patentansprüche**

1. Einzelwiderstandsmessverfahren für ein Motorsteuerungssystem, wobei das Motorsteuerungssystem eine dreiphasige Wechselrichterbrücke und einen einzelnen Abtastwiderstand umfasst, der einem Minuspol eines Gleichstrombusses entspricht, wobei die dreiphasige Wechselrichterbrücke so konfiguriert ist, dass sie einen Motor antreibt, um betrieben zu werden, wobei das Verfahren Folgendes umfasst:

    (S10) Erhalten eines Gleichstrom-Busstroms, der durch den einzelnen Abtastwiderstand strömt, und Bestimmen eines Einschaltstroms anhand des Gleichstrom-Busstroms, wenn eine untere Röhre von mindestens einem Phasenbrückenzweig in der dreiphasigen Wechselrichterbrücke eingeschaltet wird;
    (S20) Erhalten eines Spannungsabfalls an der Röhre, wenn die untere Röhre des mindestens einen Phasenbrückenzweigs in der dreiphasigen Wechselrichterbrücke eingeschaltet wird;

    **dadurch gekennzeichnet, dass** das Verfahren ferner Folgendes umfasst:

    (S30) Bestimmen, anhand des Einschaltstroms und des Spannungsabfalls an der Röhre, wenn die untere Röhre des mindestens einen Phasenbrückenzweigs in der dreiphasigen Wechselrichterbrücke eingeschaltet ist, eines Einschaltwiderstands, wenn die untere Röhre des mindestens einen Phasenbrückenzweigs in der dreiphasigen Wechselrichterbrücke eingeschaltet ist; und
    (S40) Bestimmen, anhand des Gleichstrom-Busstroms, eines dreiphasigen Stroms außerhalb einer Strommess-Totzone; Bestimmen, anhand des Spannungsabfalls an der Röhre und des Einschaltwiderstands, eines dreiphasigen Stroms innerhalb der Strommess-Totzone; und Bestimmen, anhand des dreiphasigen Stroms außerhalb der Strommess-Totzone und des dreiphasigen Stroms innerhalb der Strommess-Totzone, eines dreiphasigen Rückkopplungsstroms des Motors.

2. Verfahren nach Anspruch 1, ferner umfassend:

    Erhalten eines Spannungsabfalls außerhalb der Röhre, wenn die untere Röhre des mindestens einen Phasenbrückenzweigs in der dreiphasigen Wechselrichterbrücke ausgeschaltet wird; und
    Bestimmen, anhand des Spannungsabfalls außerhalb der Röhre, einer dreiphasigen Ausgangsleitungsspannung des Motors und einer Gleichstrom-Busspannung des Motors.

3. Verfahren nach Anspruch 2, ferner umfassend, vor dem Erhalten des Gleichstrom-Busstroms und des Spannungsabfalls an der Röhre:
Bestimmen einer ersten Abtastfensterzeitspanne, einer zweiten Abtastfensterzeitspanne und einer dritten Abtastfensterzeitspanne, wobei:

    die erste Abtastfensterzeitspanne eine Zeitspanne ist, die von einem Zeitpunkt der Unterlaufunterbrechung einer PWM-Dreieckswellenform bis zu einem Zeitpunkt beginnt, an dem eine obere Röhre eines beliebigen Phasenbrückenzweigs in der dreiphasigen Wechselrichterbrücke eingeschaltet wird;
    die zweite Abtastfensterzeitspanne eine Zeitspanne ist, die von einem Zeitpunkt, zu dem die obere Röhre eines beliebigen Phasenbrückenzweigs in der dreiphasigen Wechselrichterbrücke eingeschaltet wird, beginnt und um eine erste vorbestimmte Zeitspanne bis zu einem Zeitpunkt verzögert wird, zu dem eine obere Röhre eines nächsten Phasenbrückenzweigs in der dreiphasigen Wechselrichterbrücke eingeschaltet wird; und
    die dritte Abtastfensterzeitspanne eine Zeitspanne ist, die von einem Zeitpunkt, zu dem die obere Röhre des nächsten Phasenbrückenzweigs in der dreiphasigen Wechselrichterbrücke eingeschaltet wird, beginnt und um eine erste vorbestimmte Zeitspanne bis zu einem Zeitpunkt verzögert wird, zu dem eine obere Röhre einer letzten Phasenbrückenzweigs in der dreiphasigen Wechselrichterbrücke eingeschaltet wird.

4. Verfahren nach Anspruch 3, wobei das Bestimmen, anhand des Gleichstrom-Busstroms, des Einschaltstroms, wenn die untere Röhre des mindestens einen Phasenbrückenzweigs in der dreiphasigen Wechselrichterbrücke eingeschaltet wird, Folgendes umfasst:

    Erhalten eines Phasenstroms des Motors durch Abtasten des Gleichstrom-Busstroms während der zweiten Abtastfensterzeitspanne und der dritten Abtastfensterzeitspanne; und
    Bestimmen, anhand des Phasenstroms des Motors, des Einschaltstroms, wenn das untere Rohr des mindestens einen Phasenbrückenzweigs in der dreiphasigen Wechselrichterbrücke eingeschaltet wird.

5. Verfahren nach Anspruch 3, wobei das (S20) Erhalten des Spannungsabfalls an der Röhre, wenn die untere Röhre des mindestens einen Phasenbrückenzweigs in der dreiphasigen Wechselrichterbrücke eingeschaltet wird, Folgendes umfasst:
Erhalten des Spannungsabfalls an der Röhre, wenn die untere Röhre des mindestens einen Phasenbrückenzweigs in der dreiphasigen Wechselrichterbrücke eingeschaltet ist, durch Abtasten der Spannungsabfälle an der Röhre während mindestens einer der ersten Abtastfensterzeitspanne, der zweiten Abtastfensterzeitspanne und der dritten Abtastfensterzeitspanne.

6. Verfahren nach Anspruch 2, ferner umfassend, vor der Erhalten des Spannungsabfalls außerhalb der Röhre:
Bestimmen, anhand einer zeitlichen Abfolge von einzuschaltenden Schaltröhren in der dreiphasigen Wechselrichterbrücke, einer vierten Abtastfensterzeitspanne, wobei die vierte Abtastfensterzeitspanne eine Zeitspanne ist, die von einem Zeitpunkt der Überlaufunterbrechung einer PWM-Dreieckswellenform bis zu einem Zeitpunkt beginnt, an dem eine obere Röhre eines beliebigen Phasenbrückenzweigs in der dreiphasigen Wechselrichterbrücke ausgeschaltet wird.

7. Verfahren nach Anspruch 6, wobei das Erhalten des Spannungsabfalls außerhalb der Röhre, wenn die untere Röhre des mindestens einen Phasenbrückenzweigs in der dreiphasigen Wechselrichterbrücke ausgeschaltet wird, Folgendes umfasst:
Erhalten des Spannungsabfalls außerhalb der Röhre, wenn die untere Röhre des mindestens einen Phasenbrückenzweigs in der dreiphasigen Wechselrichterbrücke ausgeschaltet ist, durch Abtasten der Spannungsabfälle außerhalb der Röhre während mindestens einer der zweiten Abtastfensterzeitspanne, der dritten Abtastfensterzeitspanne und der vierten Abtastfensterzeitspanne.

8. Motorsteuerungsverfahren, umfassend:

(S110) Erhalten des dreiphasigen Rückkopplungsstroms des Motors und einer dreiphasigen Ausgangsleitungsspannung des Motors durch Ausführen eines Einzelwiderstandsmessverfahrens für das Motorsteuerungssystem nach einem der Ansprüche 1 bis 7;
(S120) Erhalten eines Gleichstroms und eines Querstroms durch Ausführen einer Koordinatentransformation in den dreiphasigen Rückkopplungsstrom, und Erhalten einer Gleichachsspannung und einer Querspannung durch Ausführen einer Koordinatentransformation in die dreiphasige Ausgangsleitungsspannung;
(S130) Erhalten eines Rotorwinkels und einer Rotordrehzahl des Motors durch Ausführen einer Magnetflussverknüpfung und Drehzahlbeobachtung anhand des Gleichstroms, des Querstroms, der Gleichachsspannung und der Querspannung; und
(S140) Durchführen der Vektorsteuerung des Motors anhand des Gleichstroms, des Querstroms, des Rotorwinkels und der Rotordrehzahl.

9. Motorsteuerung, umfassend:

einen Speicher
einen Prozessor; und
ein Einzelwiderstandsmessprogramm für ein Motorsteuerungssystem, das in dem Speicher gespeichert und auf dem Prozessor ausführbar ist,
wobei der Prozessor so konfiguriert ist, dass er beim Ausführen des Einzelwiderstandsmessprogramms ein Einzelwiderstandsmessverfahren für das Motorsteuerungssystem nach einem der Ansprüche 1 bis 7 implementiert.

10. Computerlesbares Speichermedium, das ein Einzelwiderstandsmessprogramm für ein Motorsteuerungssystem aufweist, das auf diesem gespeichert ist, wobei das Einzelwiderstandsmessprogramm für das Motorsteuerungssystem so konfiguriert ist, dass es, wenn es von einem Prozessor ausgeführt wird, ein Einzelwiderstandsmessverfahren für das Motorsteuerungssystem nach einem der Ansprüche 1 bis 7 implementiert.

11. Motorsteuerungssystem, umfassend:

einen Motor;
eine dreiphasige Wechselrichterbrücke (10), die zwischen Gleichstrombussen geschaltet und so konfiguriert ist, dass sie den Motor antreibt, um betrieben zu werden;
eine Strommesseinheit (20), die einen einzelnen Abtastwiderstand umfasst, wobei der einzelne Abtastwiderstand entsprechend einem Minuspol des Gleichstrombusses angeordnet und so konfiguriert ist, dass er einen Gleichstrom-Busstrom misst;

eine erste Spannungsmesseinheit (30), die entsprechend einer unteren Röhre eines U-Phasenbrückenzweigs in der dreiphasigen Wechselrichterbrücke (10) angeordnet und so konfiguriert ist, dass sie einen Spannungsabfall der unteren Röhre des U-Phasenbrückenzweigs misst;

eine zweite Spannungsmesseinheit (40), die entsprechend einer unteren Röhre eines V-Phasenbrückenzweigs in der dreiphasigen Wechselrichterbrücke (10) angeordnet und so konfiguriert ist, dass sie einen Spannungsabfall der unteren Röhre des V-Phasenbrückenzweigs misst;

eine dritte Spannungsmesseinheit (50), die entsprechend einer unteren Röhre eines W-Phasenbrückenzweigs in der dreiphasigen Wechselrichterbrücke (10) angeordnet und so konfiguriert ist, dass sie einen Spannungsabfall der unteren Röhre des W-Phasenbrückenzweigs misst;

eine Steuereinheit, die konfiguriert ist zum:

Bestimmen, anhand des Gleichstrom-Busstroms eines Einschaltstroms, wenn eine untere Röhre von mindestens einem Phasenbrückenzweig in der dreiphasigen Wechselrichterbrücke (10) eingeschaltet wird, Erhalten eines Spannungsabfalls an der Röhre, wenn die untere Röhre des mindestens einen Phasenbrückenzweigs in der dreiphasigen Wechselrichterbrücke (10) eingeschaltet wird,

Bestimmen, anhand des Einschaltstroms und des Spannungsabfalls an der Röhre, wenn die untere Röhre des mindestens einen Phasenbrückenzweigs in der dreiphasigen Wechselrichterbrücke (10) eingeschaltet ist, eines Einschaltwiderstands, wenn die untere Röhre des mindestens einen Phasenbrückenzweigs in der dreiphasigen Wechselrichterbrücke (10) eingeschaltet ist,

Bestimmen, anhand des Gleichstrom-Busstroms, eines dreiphasigen Stroms außerhalb einer Strommess-Totzone, und

Bestimmen, anhand des Spannungsabfalls an der Röhre und des Einschaltwiderstands, eines dreiphasigen Stroms innerhalb der Strommess-Totzone,

wobei die Steuereinheit ferner so konfiguriert ist, dass sie anhand des dreiphasigen Stroms außerhalb der Strommess-Totzone und des dreiphasigen Stroms innerhalb der Strommess-Totzone einen dreiphasigen Rückkopplungsstrom des Motors bestimmt.

**12.** Motorsteuerungssystem nach Anspruch 11, wobei die Steuereinheit ferner konfiguriert ist zum:

Erhalten eines Spannungsabfalls außerhalb der Röhre, wenn die untere Röhre des mindestens einen Phasenbrückenzweigs in der dreiphasigen Wechselrichterbrücke (10) ausgeschaltet wird; und

Bestimmen, anhand des Spannungsabfalls außerhalb der Röhre, einer dreiphasigen Ausgangsleitungsspannung des Motors und einer Gleichstrom-Busspannung des Motors.

**13.** Motorsteuerungssystem nach Anspruch 12, wobei die Steuereinheit ferner konfiguriert ist zum:

Erhalten eines Gleichstroms und eines Querstroms durch Ausführen einer Koordinatentransformation in den dreiphasigen Rückkopplungsstrom, und Erhalten einer Gleichachsspannung und einer Querspannung durch Ausführen einer Koordinatentransformation in die dreiphasige Ausgangsleitungsspannung;

Erhalten eines Rotorwinkels und einer Rotordrehzahl des Motors durch Ausführen einer Magnetflussverknüpfung und Drehzahlbeobachtung anhand des Gleichstroms, des Querstroms, der Gleichachsspannung und der Querspannung; und

Durchführen der Vektorsteuerung des Motors anhand des Gleichstroms, des Querstroms, des Rotorwinkels und der Rotordrehzahl.

**Revendications**

**1.** Procédé de mesure à résistance unique pour un système de commande de moteur, le système de commande de moteur comprenant un pont onduleur triphasé et une résistance d'échantillonnage unique correspondant à un pôle négatif d'un bus de courant continu, le pont onduleur triphasé étant configuré pour entraîner un moteur à fonctionner, le procédé comprenant :

(E10) l'obtention d'un courant de bus de courant continu circulant à travers la résistance d'échantillonnage unique, et la détermination, sur la base du courant de bus de courant continu, d'un courant de mise en marche lorsqu'un tube inférieur d'au moins un bras de pont de phase dans le pont onduleur triphasé est mis en marche ;

(E20) l'obtention d'une chute de tension sur le tube lorsque le tube inférieur de l'au moins un bras de pont de phase dans le pont onduleur triphasé est mis en marche ;

**caractérisé en ce que** le procédé comprend en outre :

(E30) la détermination, sur la base du courant de mise en marche et de la chute de tension sur le tube lorsque le tube inférieur de l'au moins un bras de pont de phase dans le pont onduleur triphasé est mis en marche, d'une résistance de mise en marche lorsque le tube inférieur de l'au moins un bras de pont de phase dans le pont onduleur triphasé est mis en en marche ; et

(E40) la détermination, sur la base du courant de bus de courant continu, d'un courant triphasé à l'extérieur d'une zone morte de mesure de courant ; la détermination, sur la base de la chute de tension sur le tube et de la résistance de mise en marche, d'un courant triphasé à l'intérieur de la zone morte de mesure de courant ; et la détermination, sur la base du courant triphasé à l'extérieur de la zone morte de mesure de courant et du courant triphasé à l'intérieur de la zone morte de mesure de courant, d'un courant de rétroaction triphasé du moteur.

2. Procédé selon la revendication 1, comprenant en outre :

l'obtention d'une chute de tension hors tube lorsque le tube inférieur de l'au moins un bras de pont de phase dans le pont onduleur triphasé est désactivé ; et
la détermination, sur la base de la chute de tension hors tube, d'une tension de ligne de sortie triphasée du moteur et d'une tension de bus de courant continu du moteur.

3. Procédé selon la revendication 2, comprenant en outre, avant ladite obtention du courant de bus de courant continu et de la chute de tension sur le tube :
la détermination d'une première période de temps de fenêtre d'échantillonnage, d'une deuxième période de temps de fenêtre d'échantillonnage et d'une troisième période de temps de fenêtre d'échantillonnage, dans lequel :

la première période de temps de fenêtre d'échantillonnage est une période de temps commençant à partir d'un moment d'interruption de sous-dépassement d'une forme d'onde triangulaire PWM jusqu'à un moment où un tube supérieur d'un bras de pont de phase quelconque dans le pont onduleur triphasé est mis en marche ;
la deuxième période de temps de fenêtre d'échantillonnage est une période de temps commençant à un moment où le tube supérieur d'un bras de pont de phase quelconque dans le pont onduleur triphasé est mis en marche et retardé pendant une première période de temps prédéterminée, jusqu'à un moment où un tube supérieur d'un bras de pont de phase suivant dans le pont onduleur triphasé est mis en marche ; et
la troisième période de temps de fenêtre d'échantillonnage est une période de temps commençant à un moment où le tube supérieur du bras de pont de phase suivant dans le pont onduleur triphasé est mis en marche et retardé pendant la première période de temps prédéterminée, à un moment où un tube supérieur d'un dernier bras de pont de phase dans le pont onduleur triphasé est mis en marche.

4. Procédé selon la revendication 3, dans lequel ladite détermination, sur la base du courant de bus de courant continu, du courant de mise en marche lorsque le tube inférieur de l'au moins un bras de pont de phase dans le pont onduleur triphasé est mis en marche comprend :

l'obtention d'un courant de phase du moteur en échantillonnant le courant de bus de courant continu pendant la deuxième période de temps de fenêtre d'échantillonnage et la troisième période de temps de fenêtre d'échantillonnage ; et
la détermination, sur la base du courant de phase du moteur, du courant de mise en marche lorsque le tube inférieur de l'au moins un bras de pont de phase dans le pont onduleur triphasé est mis en marche.

5. Procédé selon la revendication 3, dans lequel ladite (E20) obtention de la chute de tension sur le tube lorsque le tube inférieur de l'au moins un bras de pont de phase dans le pont onduleur triphasé est mis en marche comprend :
l'obtention de la chute de tension sur le tube lorsque le tube inférieur de l'au moins un bras de pont de phase dans le pont onduleur triphasé est mis en marche en échantillonnant des chutes de tension sur le tube pendant au moins une de la première période de temps de fenêtre d'échantillonnage, de la deuxième période de temps de fenêtre d'échantillonnage et de la troisième période de temps de fenêtre d'échantillonnage.

6. Procédé selon la revendication 2, comprenant en outre, avant ladite obtention de la chute de tension hors tube :
la détermination, sur la base d'une séquence temporelle de tubes de commutation à mettre en marche dans le pont onduleur triphasé, d'une quatrième période de temps de fenêtre d'échantillonnage, dans lequel la quatrième période de temps de fenêtre d'échantillonnage est une période de temps commençant à partir d'un moment d'interruption de débordement d'une forme d'onde triangulaire PWM jusqu'à un moment où un tube supérieur d'un bras de pont de phase quelconque dans le pont onduleur triphasé est désactivé.

7. Procédé selon la revendication 6, dans lequel ladite obtention de la chute de tension hors tube lorsque le tube inférieur de l'au moins un bras de pont de phase dans le pont onduleur triphasé est désactivé comprend :
l'obtention de la chute de tension hors tube lorsque le tube inférieur de l'au moins un bras de pont de phase dans le pont onduleur triphasé est désactivé en échantillonnant des chutes de tension hors tube pendant au moins une de la deuxième période de temps de fenêtre d'échantillonnage, de la troisième période de temps de fenêtre d'échantillonnage, et de la quatrième période de temps de fenêtre d'échantillonnage.

8. Procédé de commande de moteur, comprenant :

(E110) l'obtention du courant de rétroaction triphasé du moteur et d'une tension de ligne de sortie triphasée du moteur en réalisant un procédé de mesure à résistance unique pour le système de commande de moteur selon l'une quelconque des revendications 1 à 7 ;
(E120) l'obtention d'un courant continu et d'un courant d'axe en quadrature en effectuant une transformation de coordonnées sur le courant de rétroaction triphasé, et l'obtention d'une tension d'axe continu et une tension d'axe en quadrature en effectuant une transformation de coordonnées sur la tension de ligne de sortie triphasée ;
(E130) l'obtention d'un angle de rotor et d'une vitesse de rotor du moteur en effectuant une liaison de flux magnétique et une observation de vitesse sur la base du courant continu, du courant d'axe en quadrature, de la tension d'axe continu et de la tension d'axe en quadrature ; et
(E140) la réalisation d'une commande vectorielle du moteur sur la base du courant continu, du courant d'axe en quadrature, de l'angle de rotor et de la vitesse de rotor.

9. Dispositif de commande de moteur, comprenant :

une mémoire ;
un processeur ; et
un programme de mesure à résistance unique pour un système de commande de moteur stocké sur la mémoire et pouvant être exécuté sur le processeur,
dans lequel le processeur est configuré pour, lors de l'exécution du programme de mesure à résistance unique, mettre en œuvre un procédé de mesure à résistance unique pour le système de commande de moteur selon l'une quelconque des revendications 1 à 7.

10. Support de stockage lisible par ordinateur, présentant un programme de mesure à résistance unique pour un système de commande de moteur stocké sur celui-ci, le programme de mesure à résistance unique pour le système de commande de moteur étant configuré pour, lorsqu'il est exécuté par un processeur, mettre en œuvre un procédé de mesure à résistance unique pour le système de commande de moteur selon l'une quelconque des revendications 1 à 7.

11. Système de commande de moteur, comprenant :

un moteur ;
un pont onduleur triphasé (10) connecté entre des bus de courant continu et configuré pour entraîner le moteur à fonctionner ;
une unité de mesure de courant (20) comprenant une résistance unique d'échantillonnage, la résistance unique d'échantillonnage étant disposée en correspondance avec un pôle négatif du bus de courant continu et configurée pour mesurer un courant de bus de courant continu ;
une première unité de mesure de tension (30) disposée en correspondance avec un tube inférieur d'un bras de pont de phase en U dans le pont onduleur triphasé (10) et configurée pour mesurer une chute de tension de tube inférieur du bras de pont de phase en U ;
une deuxième unité de mesure de tension (40) disposée en correspondance avec un tube inférieur d'un bras de pont de phase en V dans le pont onduleur triphasé (10) et configurée pour mesurer une chute de tension de tube inférieur du bras de pont de phase en V ;
une troisième unité de mesure de tension (50) disposée en correspondance avec un tube inférieur d'un bras de pont de phase en W dans le pont onduleur triphasé (10) et configurée pour mesurer une chute de tension de tube inférieur du bras de pont de phase en W ;
une unité de commande configurée pour :

déterminer, sur la base du courant de bus de courant continu, un courant de mise en marche lorsqu'un tube inférieur d'au moins un bras de pont de phase dans le pont onduleur triphasé (10) est mis en marche, obtenir une chute de tension sur le tube lorsque le tube inférieur de l'au moins un bras de pont de phase dans le pont onduleur triphasé (10) est mis en marche, déterminer, sur la base du courant de mise en marche et de la chute de tension sur le tube lorsque le tube inférieur de l'au moins un bras de pont de phase dans le pont onduleur triphasé (10) est mis en marche, une résistance de mise en marche lorsque le tube inférieur de l'au moins un bras de pont de phase dans le pont onduleur triphasé (10) est mis en marche, déterminer, sur la base du courant de bus de courant continu, un courant triphasé en dehors d'une zone morte de mesure de courant, et déterminer, sur la base de la chute de tension sur le tube et de la résistance de mise en marche, un courant triphasé à l'intérieur de la zone morte de mesure de courant, dans lequel l'unité de commande est en outre configurée pour déterminer, sur la base du courant triphasé à l'extérieur de la zone morte de mesure de courant et du courant triphasé à l'intérieur de la zone morte de mesure de courant, un courant de rétroaction triphasé du moteur.

12. Système de commande de moteur selon la revendication 11, dans lequel l'unité de commande est en outre configurée pour :

obtenir une chute de tension hors tube lorsque le tube inférieur de l'au moins un bras de pont de phase dans le pont onduleur triphasé (10) est désactivé ; et
déterminer, sur la base de la chute de tension hors tube, une tension de ligne de sortie triphasée du moteur et une tension de bus de courant continu du moteur.

13. Système de commande de moteur selon la revendication 12, dans lequel l'unité de commande est en outre configurée pour :

obtenir un courant continu et un courant d'axe en quadrature en réalisant une transformation de coordonnées au courant de rétroaction triphasé, et obtenir une tension d'axe continu et une tension d'axe en quadrature en réalisant une transformation de coordonnées à la tension de ligne de sortie triphasée ;
obtenir un angle de rotor et une vitesse de rotor du moteur en réalisant une liaison de flux magnétique et une observation de vitesse sur la base du courant continu, du courant d'axe en quadrature, de la tension d'axe continu et de la tension d'axe en quadrature ; et
réaliser une commande vectorielle du moteur sur la base du courant continu, du courant d'axe en quadrature, de l'angle de rotor et de la vitesse de rotor.

FIG. 1

Obtaining a direct-current bus current flowing through the single sampling resistor, and determining, based on the direct-current bus current, a switch-on current when a lower tube of at least one phase bridge arm in the three-phase inverter bridge is switched on

S10

Obtaining an on-tube voltage drop when the lower tube of the at least one phase bridge arm in the three-phase inverter bridge is switched on

S20

Determining, based on the switch-on current and the on-tube voltage drop when the lower tube of the at least one phase bridge arm in the three-phase inverter bridge is switched on, a switch-on resistance when the lower tube of the at least one phase bridge arm in the three-phase inverter bridge is switched on

S30

Determining, based on the direct-current bus current, a three-phase current outside a current measurement dead zone; determining, based on the on-tube voltage drop and the switch-on resistance, a three-phase current inside the current measurement dead zone; and determining, based on the three-phase current outside the current measurement dead zone and the three-phase current inside the current measurement dead zone, a three-phase feedback current of the motor

S40

FIG. 2

FIG. 3

FIG. 4

| Obtaining the three-phase feedback current of the motor and a three-phase output line voltage of the motor by performing the above single-resistor measurement method for the motor control system | S110 |

| Obtaining a direct-current current and a quadrature-axis current by performing a coordinate transformation on the three-phase feedback current, and obtaining a direct-axis voltage and a quadrature-axis voltage by performing a coordinate transformation on the three-phase output line voltage | S120 |

| Obtaining a rotor angle and a rotor speed of the motor by performing a magnetic flux linkage and speed observation based on the direct-current current, the quadrature-axis current, the direct-axis voltage, and the quadrature-axis voltage | S130 |

| Performing vector control of the motor based on the direct-current current, the quadrature-axis current, the rotor angle, and the rotor speed | S140 |

FIG. 5

PM Motor

Coordinate transformation + SVPWM

θ

Current PI

Current PI

Speed PI

Non-dead zone current restoration

Dead zone current restoration

Current synthesis restoration

Terminal voltage sampling restoration

Iu、Iv、Iw

Vuv、Vvw、Vwu

Coordinate transformation

θ

Coordinate transformation

θ

Iq* −
+ Iq

Id* = 0 −
+ Id

Iq

Id

Vq

Vd

Magnetic flux linkage and speed observer

ω* +
− ω

1/S

θ

FIG.6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111655481
- US 2020274471 A